# EUROPEAN PATENT APPLICATION

(11) **EP 2 253 997 A2**
(43) Date of publication of application: **24.11.2010**
(21) Application number: 09169158.4
(22) Date of filing: 01.09.2009
(51) Int. Cl.: G03F 7/20

(54) **Illumination system for a microlithographic contact and proximity exposure apparatus**

(30) Priority: 18.05.2009 EP 09160535
(71) Applicant: Süss MicroTec Lithography GmbH, 85748 Garching (DE)
(72) Inventor: Völkel, Reinhard, 2000, Neuchâtel (CH); Vogler, Uwe, 07422, Bad Blankenburg (DE); Bich, Andreas, 2034, Peseux (CH); Weible, Kenneth J., 2000, Neuchâtel (CH); Eisner, Martin, 2000, Neuchâtel (CH); Hornung, Michael, 85406, Zolling (DE); Kaiser, Paul, 81539, München (DE); Zoberbier, Ralph, 85276, Pfaffenhofen (DE); Cullmann, Elmar, 82194, Gröbenzell (DE)
(74) Representative: Heunemann, Dieter

(57) **Abstract**

An illumination system for a micro-lithographic contact and proximity exposure apparatus comprising a light source (1), a collector (2), two optical integrators (3,6), two Fourier lenses (4,7), at least one angle defining element (5); and at least one field lens (8). The first optical integrator (3) comprises optical sub-elements and produces a plurality of secondary light sources (6a) each emitting a light bundle. A first Fourier lens (7) effects a superposition of the light bundles and uniform irradiance in its Fourier plane (4a). The second optical integrator (6) is located at the Fourier plane (7a) of the first Fourier lnes (7), comprises optical sub-elements and produces a plurality of tertiary light sources (6a) each emitting a light bundle. A second Fourier lens (7) effects a superposition of the light bundles, uniform irradiance and a desired and uniform angular distribution of light illuminating a mask (9) for contact or proximity lithographic printing. The field lens (8) in the Fourier plane (7a) ensures telecentric illumination the mask (9). The optional field lens (12) in the Fourier plane (4a) of the first optical integrator (3) ensures telecentric illumination of the second optical integrator (6). The angle defining element (5) comprises optical sub-elements and defines the angular distribution of the light illuminating the mask (9). A change of the position of the second Fourier lens (7) or the use of a Fourier zoom lens (62) or hybrid Fourier lens (63) allows run-out control (registration error correction) of the lateral dimensions of the printed miniature pattern in the resist layer on the surface of the wafer (10).

## Description

### BACKGROUND OF THE INVENTION

### 1. Field of the invention

The invention relates generally to illumination systems for microlithographic contact and proximity exposure apparatus. More particularly, the invention relates to illumination systems comprising two optical integrators that produce a plurality of secondary and tertiary light sources.

### 2. Description of Related Art

Microlithography (also called photolithography or simply lithography) is a technology for the fabrication of integrated circuits, liquid crystal displays and other microstructured devices. The process of microlithography, in conjunction with the process of etching, is used to pattern features on a substrate, for example a silicon or glass wafer. At each layer of the fabrication, the wafer is first coated with a photoresist which is a material that is sensitive to radiation, such as ultraviolet (UV) light. Next, the wafer with the photoresist on top is exposed to light through a mask in a contact or proximity exposure apparatus, usually called a mask aligner. The mask contains a circuit pattern to be transferred onto the photoresist by shadow-printing. After exposure the photoresist is developed to produce an image corresponding to the circuit pattern contained in the mask.

A contact and proximity exposure apparatus typically includes an illumination system, a mask stage for a aligning the mask and a wafer alignment stage for aligning the wafer coated with the photoresist. The illumination system illuminates a field on the mask that often has the shape of a square or a circle.

In current contact and proximity exposure apparatus a distinction can be made between two different types of lithographic exposure process. In one type the wafer is exposed whilst the resist layer onto the wafer and the mask pattern are in direct contact to each other; such a lithographic process is commonly referred to as a contact printing. In the other type of lithographic exposure process, which is commonly referred to as proximity printing, the resist layer onto the wafer and the mask pattern are at a certain distance to each other, usually some microns up to some hundred microns.

It is to be understood that the term "mask" (or reticle) is to be interpreted broadly as a patterning means. Commonly used masks contain transparent or reflective patterns and may be of the binary, alternating phase-shift, attenuated phase-shift or various hybrid mask type, for example. However, there are also active masks, e.g. masks realized as a programmable micro-mirror or LCD arrays; as well modified and optimized masks using for example rule-based optical proximity correction (OPC). For the sake of simplicity, the rest of this text may specifically relate to apparatus comprising a mask; however, the general principles discussed in such apparatus should be seen in the broader context of the patterning means as here above set forth.

As the technology for manufacturing microstructured devices advances, there are ever increasing demands also on the illumination system. Ideally, the illumination system illuminates each point of the illuminated field on the mask with exposure light having a well defined angular distribution and irradiance. Usually the angular distribution of the exposure light and the irradiance shall be the same for all points in the illuminated field.

The performance of a lithographic exposure is determined by two parameters: resolution, also referred to as critical dimension (CD), and registration. Resolution is defined to be the minimum feature dimension that can be transferred with high fidelity to a resist layer on a wafer. Registration is a measure of how accurately patterns on successive masks can be aligned or overlaid with respect to previously defined patterns on the same wafer. Diffraction effects limit the resolution and fidelity of miniature pattern generated or printed by lithography. Apodization is a method to suppress diffraction effects like side lobes, higher orders and interference. For microlithographic contact and proximity exposure apparatus apodization is provided by illumination of the mask with an angular spectrum comprising a desired set of angles, whereas the amount of light impinging on the mask with perpendicular incidence is significantly reduced. Apodization is often achieved by blocking the central area of a lens or an optical integrator.

The angular distribution of the light impinging on the mask is usually adapted to the kind of pattern to be printed onto the photoresist. For example, relatively large sized features may require a different angular distribution than small sized features. The most commonly used angular distributions of exposure light are referred to as conventional, annular, dipole and quadrupole illumination settings. These terms refer to the irradiance distribution in a pupil plane of the illumination system. With an annular illumination setting, for example, only an annular region is illuminated in the pupil plane, and thus there is only a small range of angles present in the angular distribution of the exposure light so that all light beams impinge obliquely with similar angles onto the mask.

Resolution, registration errors and diffraction effects are also corrected by pre-compensating the pattern on the mask. This technique is often referred to as optical proximity correction (OPC). Optical proximity correction is a method to suppress diffraction effects like side lobes, higher orders, interference pattern, edge and line end rounding by using additional structures referred to as corner serifs, hammerhead pattern, assist lines, line breaks, dot mesas, rings and mouse-bites in the mask pattern. Optical proximity correction is usually applied for imaging and projection lithography systems where the angular spectrum and the partial coherence of the mask illumination is well defined and controlled. For microlithographic contact and proximity exposure apparatus this was not the case prior to this invention, thus optical proximity correction was not applicable. The illumination system of the described invention allows to shape both the angular spectrum and the spatial coherence precisely, thus allowing optical proximity correction (OPC) in an microlithographic contact and proximity exposure apparatus. It is an advantage of the present invention that both, the illumination and the optical proximity correction structures may be well adapted to the individual mask structures.

In illumination systems designed for contact or proximity exposure in a mask aligner, high intensity arc lamps or UV-LEDs, providing light in the Ultraviolet wavelength range, are used as initial light source. As arc lamps and UV-LEDs emit the light in a very large angular range, reflecting mirrors and condenser lenses are used to collect the light from the light source.

The exposure light bundle emitted by an arc lamp or UV-LED and collected by reflecting mirrors and condenser lenses has a large cross section and a high divergence, and therefore also the geometrical optical flux is high. The geometrical optical flux, which is also referred to as the Etendue or the Lagrange invariant, is a quantity that is, at least for certain special configurations, proportional to the product of maximum light angle and size of the illuminated field. The large optical geomettical flux of an arc lamp or UV-LED light sources implies that - if only conventional mirror and lenses are used - it is only possible to achieve a large field illuminated with large illumination angles.

For achieving illumination of a large field with a good irradiance uniformity, most illumination systems contain optical elements that increase, for each point on the element, the divergence of light passing this point and homogenize the light. Optical elements having this property will in the following be generally referred to as optical integrator elements.

An optical integrator element produces a plurality of secondary light sources, increases the geometrical optical flux and modifies the size and geometry of the illuminated field on the mask. Due to this property the optical integrator is also referred to as field defining element.

Such optical integrator elements comprise a plurality of - usually periodically arranged - sub-elements, for example lens arrays, microlens arrays, diffractive structures, refractive structures, random diffuser plates, optical free-form elements, mirrors, mirror arrays, pinhole arrays and arrays of glass rods or fibers.

Lens or microlens arrays comprise cylindrical lenses, square lenses, rectangular lenses, hexagonal lenses, circular lenses, free-form and randomly shaped lenses. They are arranged in a regular packed, hexagonal densely packed or randomly packed array. Free-form lens shapes in non-periodic packaging are used to reduce interference and speckle effects. Cross-cylindrical arrays comprising two cylindrical microlenses with perpendicular arrangement allow different angular divergence in x- and y-direction.

Optical integrator elements based on array optics are also referred as fly's eye condenser, Köhler integrator, lenticular integrator, beam homogenizer, array homogenizer and Gabor superlens. Optical integrators also comprise other type of light mixing elements suitable for achieving illumination of a large field with a good irradiance uniformity, like glass rods, also referred as Kaleidoscope, glass plates, multimode fibers, light guides or liquid light guides.

Optical integrators are often followed by a lens. This lens is referred in literature as condenser, collimator, field or Fourier lens. The lens superposes the light from the different secondary light sources produced by the optical integrator elements. Optimum superposition and best irradiance uniformity is achieved in a plane, located at a focal length distance behind this lens. The focal plane of the Fourier lens is referred as Fourier plane. A circular, hexagonal, rectangular, square or free-form shaped area with good irradiance uniformity, referred as flat-top or top-hat, is observed. The irradiance in this plane corresponds to the Fourier transformation of the angular spectrum produced by the optical integrator. The terminus condenser lens refers to optical integrators where the flat-top area is smaller than the light bundle at the entrance plane of the optical integrator. For simplicity a lens following the optical integrator is referred as Fourier lens.

A typical illumination system that achieves a good irradiance distribution is disclosed in US Pat. No. 2,186,123. Light from an arc lamp is collected by an elliptical mirror and condenser lenses and then homogenized by an optical integrator comprising two lens arrays.

A typical illumination system for a microlithography exposure system that achieves a good irradiance distribution and a defined angular divergence is disclosed in US Pat. No. 3,941,475. Light from an arc lamp is collected by an elliptical mirror. An optical integrator is placed in the focus of the elliptical mirror. Aperture plates, a field lens and a collimator lens are used to provide illumination with uniform irradiance and a defined angular divergence for a mask.

### SUMMARY OF THE INVENTION

It is an object of the present invention to provide an illumination system for a microlithographic contact and proximity exposure apparatus that makes it possible to achieve a uniform irradiance and desired angular distribution in a mask plane. More particularly, a uniform irradiance distribution shall be achieved that is substantially independent from the illumination setting.

This and other objects are achieved, according to a first aspect of the invention, by an illumination system comprising a light source and two optical integrators. The first optical integrator that may comprise optical sub-elements produces a plurality of secondary light sources each emitting a light bundle. A first Fourier lens effects a superposition of the light bundles and uniform irradiance at the entrance plane of the second optical integrator. The second optical integrator that may comprise optical sub-elements produces a plurality of tertiary light sources each emitting a light bundle. A second Fourier lens effects a superposition of the light bundles and uniform irradiance and a desired angular distribution of light illuminating a mask for contact or proximity lithographic printing. According to a second aspect of the invention, an illumination system is provided comprising a light source, two optical integrators and at least one angle defining element. The angle defining element may comprise optical sub-elements, is located at the second optical integrator and defines the areas of illumination of the entrance pupil of the secondary optical integrator.

According to a third aspect of the invention, an illumination system is provided comprising a light source, two optical integrators, two Fourier lenses, at least one angle defining element and two field lenses located in the focal planes of the Fourier lenses. According to an embodiment of the invention, an illumination system for a microlithographic contact and proximity exposure apparatus comprises:
a light source,
a collector,
a first optical integrator that produces a plurality of secondary light sources each emitting a light bundle, and
a first Fourier lens effecting a superposition of the light bundles in a Fourier plane, and
a second optical integrator that produces a plurality of tertiary light sources each emitting a light bundle, and
a second Fourier lens effecting a superposition of the light bundles in a Fourier plane, and
a field lens located in the Fourier plane of second Fourier lens,
   wherein said first and second optical integrators are configured such that a mask is illuminated with uniform irradiance and a uniform angular distribution.

Said first and second optical integrators may be configured such that a mask is illuminated with uniform irradiance and a uniform angular distribution independent from the configuration of the lamp and the collector.

Said first and second optical integrators may be configured such that a mask is illuminated with uniform irradiance and a uniform angular distribution, whereas the angular distribution is defined by an angle defining element.

A first field lens may be located in the Fourier plane of first Fourier lens and a second field lens may be located in the Fourier plane of second Fourier lens, wherein first field lens ensures telecentric illumination of the second optical integrator and the second field lens ensures telecentric illumination of the mask.

Said first and second optical integrators may comprise two sub-elements configured such that a flat-top intensity distribution is obtained in the Fourier planes of subsequent Fourier lenses.

Said sub-elements of first and second optical integrators may comprise two identical lens arrays located at a focal length distance f₁ = f₂ from each other.

Said sub-elements of first and second optical integrators may comprise two different lens arrays, whereas the first array is located at or close to the front focal plane of the second lens array.

Said lens arrays may be two-dimensional arrays of circular, quadratic or hexagonal lens shape.

Said lens arrays may be one-dimensional arrays of rectangular lens shape.

Said lens arrays may be two-dimensional arrays located on front and backside of one substrate.

Said lens arrays may be one-dimensional arrays located on front and backside of one substrate.

Said sub-elements of first and second optical integrators may comprise four identical arrays of cylindrical lenses, wherein two lens array are rotated by 90° around Z direction, wherein first sub-eleinent comprises two lens array and second sub-element comprises two lens array and wherein first lens array and third lens array are located at a focal length distance f₁ = f₃ from each other and wherein second lens array and fourth lens array are located at a focal length distance f₂ = f₄ from each other.

Said first and second optical integrators may be configured such that a mask is illuminated with uniform irradiance independent from the configuration of the angle defining element.

Said angle defining element may be a filter plate, wherein filter plate comprises transparent and opaque areas.

Said filter plate may comprises transparent and opaque areas of multiple circles.

Said filter plate may comprise transparent and opaque areas of circles of different diameter.

Said filter plate may comprise transparent and opaque areas of rings of different inner and outer diameter.

Said filter plate may comprise transparent and opaque areas of Maltese Cross 0° and 45° rotated and Quadrupole.

Said filter plate may comprise any desired distribution of transparent and opaque areas.

Said filter plate may comprise also semi-transparent areas.

Said filter plate may comprise grey-level, refractive, diffractive, phase-shifting or Fresnel-type optical elements.

Said filter plate may comprise other optical elements like lenses, prisms or beam-splitters.

Said angle defining element may comprise two variable sub-elements.

Said angle defining element may comprise a concave and a convex axicon providing annual illumination at the second optical integrator, wherein the convex axicon is variable to change the dimensions of the ring illumination.

Said angle defining element may comprise two variable sub-elements, a combination of convex axicons, pyramides or prism elements and its concave counterparts.

Said angle defining elements may comprise a light guiding rod located at a variable position prior to the second optical integrator.

Said angle defining elements may comprise a light guiding rod and a variable mirror tube, both located at a variable positions prior to the second optical integrator 6.

The outer dimensions of said light guiding rod may be slightly smaller than the inner dimensions of said variable mirror tube.

Said angle defining element may be an absorbing or reflecting axial-symmetric element located prior to the entrance pupil of the second optical integrator to block the central part (apodization) and to absorb or redirect the incident light to larger angles.

Said angle defining element may be an absorbing or reflecting axial-symmetric element located prior to the entrance pupil of the second optical integrator to block the central part (apodization) and to absorb or redirect the incident light to larger angles.

Said absorbing or reflecting axial-symmetric element may be variable in Z-direction providing annular (ring) illumination with different size of the dark zone in the center.

Said angle defining elements may comprise a light guiding rod, a variable mirror tube and an absorbing or reflecting axial-symmetric element; located at a variable positions prior to the second optical integrator.

The position and distribution of the transparent and opaque areas on said filter plate may be variable in X- and Y-direction.

The size of the transparent and opaque areas on said filter plate may be variable X- and Y-dimensions.

Said filter plate may comprise transparent, semi-transparent and opaque areas.

Said filter plate may comprise a liquid crystal display.

Said filter plate may comprise a micro-mirror array in transmission or reflection.

Lamp, collector, optical integrator and/or Fourier lens may be replaced by one or multiple light emitting flexible light guides.

Said one or multiple light emitting flexible light guides may be variable in X-,Y-,Z-direction.

Said one or multiple light emitting flexible light guides may be combined with a re-directing element, whereas the positions of said light guides and re-directing element may be variable in X-,Y-,Z-direction.

Lamp, collector, optical integrator and/or Fourier lens may be replaced by one or multiple light emitting LEDs.

Multiple light emitting LEDs may be mounted on an electronic board in a regular or annular arrangement.

Multiple light emitting LEDs may be combined with collimation optics.

The position of the second Fourier lens is variable in Z-direction to change the degree of collimation behind the second field lens.

Said change of Z-position of the second Fourier lens may introduce a change of angles of principle rays of the mask illuminating light.

Said change of angles of principle rays of the mask illuminating light may introduce a shift of the lateral position of the miniature structures transferred from the mask to the surface of the wafer by proximity printing (run-out control).

The second Fourier lens may be replaced by a Fourier zoom lens comprising two or multiple refractive lenses.

The second Fourier lens may be replaced by a hybrid Fourier lens comprising one or multiple refractive lenses and one or multiple optical elements like for example diffractive optical elements, holographic elements, radial gratings, linear gratings, axicons or axicon telescopes, prisms, or prism arrays.

The Z-position of one or multiple sub-elements may be variable.

Collector may comprise a hemispherical mirror and two half ellipsoids.

The said two half ellipsoids may have a common focal point.

Said two half ellipsoids may provide an aberration-free image of the lamp source.

Collector may comprise a two ellipsoids and a axial-symmetrical re-directing element.

Said two ellipsoids may have a common focal point.

Said two ellipsoids may provide an aberration-free image of the lamp source in the plane of the re-directing element.

Said re-directing element may change the angles of the incident light and provides a collimated bundle of light exiting the second ellipsoid through a center hole.

The said re-directing element may comprise two cones with different angles.

The said re-directing element may comprise a combination of surface reflection and total internal reflection suitable to re-direct the incident light towards the hole in the second ellipsoid.

The said re-directing element may comprise any other structure suitable to re-direct the incident light towards the hole in the second ellipsoid.

The mask and the wafer may be tilted by an angle versus the illuminating light impinging the mask.
the illumination light may be polarized.

The illumination light may be polarized by a polarizing element located in the illumination system.

Said polarizing element may be located behind the first Fourier lens.

Said polarizing element may be one or multiple plano-parallel glass plate at Brewster angle, also referred as Brewster plate polarizers.

Said polarizing element may be one or multiple plano-parallel wire-grid plate polarizers.

Said polarizing element may be any other optical element providing polarized light within a lithographic exposure apparatus.

The angle defining element may be received in an exchange holder.

The angle defining element may be received in a rotating exchange holder.

### BRIEF DESCRIPTION OF THE DRAWINGS

Various features and advantages of the present invention may be more readily understood with reference to the following detailed description taken in conjunction with the accompanying drawing in which:
- FIG. 1: is a meridional and considerably simplified view of a microlithographic contact and proximity exposure apparatus in accordance with the present invention.
- FIG. 2: is a meridional and considerably simplified view of an optical integrator followed by a Fourier lens. The back focal plane of the Fourier lens is referred as Fourier plane. A flat-top irradiance profile is observed in the Fourier plane.
- FIG. 3: is a meridional and considerably simplified view of two optical integrators, each followed by a Fourier lens. The second optical integrator is located in or nearby the Fourier plane of the first optical integrator. A field lens, also referred as front lens is located in the Fourier plane of the second Fourier lens. A mask is located nearby the front lens and illuminated.
- FIG. 4: is a meridional and considerably simplified view of two optical integrators shown to Fig. 3. An angle defining element is located at the Fourier plane of the first optical integrator.
- FIG. 5: is a meridional and considerably simplified view of two optical integrators similar to Fig. 4. A first field lens is located in or nearby the Fourier plane of the first optical integrator.
- FIG. 6: is a meridional and considerably simplified view of an optical integrator comprising two lens arrays followed by a Fourier lens.
- FIG. 7: is a meridional and considerably simplified view of an optical integrator comprising four arrays of cylindrical lenses followed by a Fourier lens.
- FIG. 8: is (a) a side view of lens arrays as used within optical integrators. (b) Top view of a regular packed array of circular shaped lenses. (c) Top view of a hexagonal packed array of circular shaped lenses.
- FIG. 9: is (a) a side view of quadratic shaped lens ar- rays as used within optical integrators. (b) Top view of a regular packed array of rectangular shaped lenses. (c) Top view of a hexagonal packed array of hexagonal shaped lenses.
- FIG. 10: is a perspective and considerably simplified view of a lens array with cylindrical lenses on both sides as used within optical integrators shown in Fig 6.
- FIG. 11: is a top view and considerably simplified view of an angle defining elements comprising (a)-(d) different configurations of annular-illumination, (e)-(h) circular-illumination, (i) and (j) ring-illumination and (k)-(l) Maltese cross illumination, (m) Quadrupole (45° tilted) illumination and (n) square or rectangular illumination, (o) square or rectangular and with Quadrupole illumination, (p) rectangular (multiple) illumination and (q) Quadrupole (45°) illumination.
- FIG. 12: is a meridional and considerably simplified view of an angle defining element comprising two variable axicon or pyramidal elements for variable ring illumination.
- FIG. 13: is a meridional and considerably simplified view of a first optical integrator comprising a glass rod and a variable mirror tube.
- FIG. 14: is a perspective and considerably simplified view of a first optical integrator comprising a glass rod and a variable mirror tube.
- FIG. 15: is a meridional and considerably simplified view of an optical integrator comprising an absorbing or reflecting axial-symmetric element located before the entrance pupil of the second optical integrator to block the central part of the optical integrator (apodization).
- FIG. 16: is a meridional and considerably simplified view of an optical integrator comprising both a light rod and variable mirror tube as shown in Fig. 13 and Fig. 14; and a variable radial cone or pyra- mid as shown in Fig. 15.
- FIG. 17: is a meridional and considerably simplified view of a collector comprising a hemispherical mirror and two half ellipsoids or paraboloids.
- FIG. 18: is a meridional and considerably simplified view of a collector comprising two ellipsoids and a light-redirecting element.
- FIG. 19: is a meridional and considerably simplified view of a redirecting element as shown in Fig. 18 us- ing a combination of surface reflection and total internal reflection.
- FIG. 20: (a) is a meridional and considerably simplified view of an angle defining element as shown in Fig. 1 and Fig 11 with transparent and opaque areas; (b)-(e) is a top-view of angle defining ele- ments with different variable configurations.
- FIG. 21: is a meridional and considerably simplified view of a microlithographic contact and proximity ex- posure apparatus in accordance with the present invention, where lamp, collector, first optical integrator and first Fourier lens are replaced by one or multiple light emitting flexible light guides. The position of the flexible light guides is variable in X-,Y-,Z-direction.
- FIG. 22: is a meridional and considerably simplified view of an optical integrator comprising one or multiple light emitting flexible light guides as shown in Fig. 21 and an absorbing or reflecting axial- symmetric element located before the entrance pupil of the second optical integrator to block the central part of the optical integrator (apodization) as shown in Fig. 15.
- FIG. 23: (a) is a meridional and considerably simplified view of a microlithographic contact and proximity exposure apparatus in accordance with the present invention, where lamp, collector and optical in- tegrator (I) are replaced by an angle defining element comprising one or multiple UV-LEDs, (b) multiple-LEDs and collimation optics. Fig. 23(c)-(e) is a top-view of an angle defining ele- ment with (c) UV-LEDs arranged in a regular pat- tern, (d) in a angular pattern and (d) top-view of an optical UV-LED emitter comprising one or more LEDs of one wavelength or different wavelengths.
- FIG. 24: is a meridional and considerably simplified view of a microlithographic contact and proximity exposure apparatus in accordance with the present invention, where the position of the second Fourier lens is variable to change the degree of collimation behind the second field lens, respectively the illumination angles of the light at the mask plane. For proximity printing a variation of the angle of the mask illuminating light is used to change the lateral dimensions of the printed pattern on the resist layer of the wafer in proximity printing (run-out control).
- FIG. 25: is a meridional and considerably simplified view of the second optical integrator as shown in Fig. 24, where second Fourier lens is replaced by an optical Zoom system comprising different positive or negative lenses or a hybrid Zoom lens comprising refractive and diffractive optical elements; both systems effect a variation of the angle of the mask illuminating light to change the lateral dimensions of the printed pattern on the resist layer of the wafer in proximity printing (run-out control).
- FIG. 26: is a meridional and considerably simplified view of a part of a microlithographic contact and proximity exposure apparatus as shown in Fig. 1, where the mask is illuminated with non-perpendicular incidence (off-axis illumination).
- FIG. 27: is a meridional and considerably simplified view of a part of a microlithographic contact and proximity exposure apparatus as shown in Fig. 1, where a polarizer is introduced (polarized light illumination).

### DESCRIPTION OF PREFERRED EMBODIMENTS

### 1. General Structure of the Illumination System for a Microlithographic Contact and Proximity Exposure apparatus

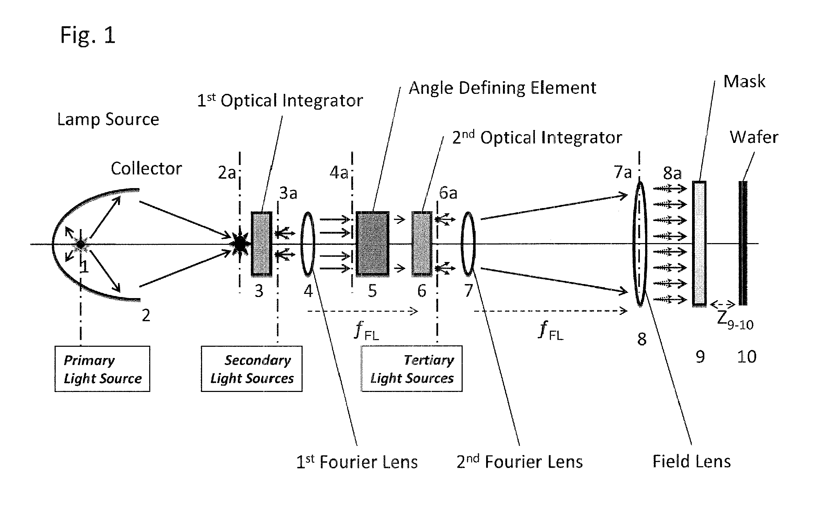

FIG. 1 shows a meridional and highly simplified view of a microlithographic contact and proximity Exposure apparatus exposure apparatus that comprises an illumination system for producing a light bundle 8a providing a well defined angular distribution and uniform irradiance. The light bundle 8a illuminates a field on a mask 9 containing minute structures. A wafer 10 with a photosensitive resist layer is in direct contact or at a proximity distance z₉₋₁₀ of typically 1 micron to 500 microns. The minute structures are transferred to the resist layer by shadow-printing. Lithography in direct contact is referred as contact lithography or contact printing, lithography at a proximity distance is referred as proximity lithography or proximity printing.

In this embodiment, the illuminated field on the mask 9 is circular or quadratic shaped. However, other, for example rectangular, shapes of the illuminated field on the mask 9 are contemplated as well.

The illumination system comprises a light source 1 that is, in the embodiment shown, realized as an arc lamp, LED, LED array, laser diode or laser; or light emitting from a light guide. The light source 1 emits light that has a wavelength range from 360 nm to 450 nm. Other types of light sources and other wavelength ranges, for example 190 nm to 450 nm and 400nm to 900nm, are also contemplated.

In the embodiment shown, the light emitted by the light source 1 enters a collector 2 in which the light is collimated or focused to a focal point 2a. After passing a first optical integrator 3 in which the light is homogenized, the angular spectra is transformed to flat-top by a first Fourier lens 4. A second optical integrator 6 is located at the back focal plane 4a of the first Fourier lens 4. After passing the second optical integrator 6 in which the light is homogenized, the angular spectra is transformed by a second Fourier lens 7 to a flat-top intensity profile 4b located in the focal plane of the second Fourier lens 7a. An angle defining element 5 is located before, inside or after the second optical integrator 6. A field lens 8, also referred as front lens 8, is located at the back focal plane 7a of the second Fourier lens 7 and collimates the illumination light. The field lens 8 ensures telecentric illumination of the mask 9. Opaque areas on the mask 9 transmit the light and illuminate the resist layer on the wafer 10, thus transferring the minute structures from the mask 9 to the wafer 10.

### 2. General Structure of the Optical Integrators

### a) First Optical Integrator

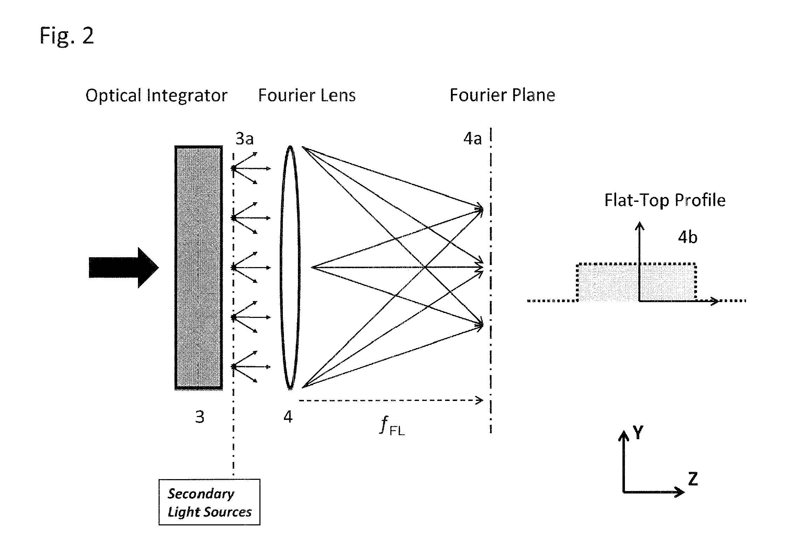

The first optical integrator 3, shown in more detail in Fig. 2, produces a plurality of secondary light sources 3a each emitting a light bundle. Ideally all secondary light sources 3a produce light bundles having the same angular distribution.

In general, the illuminated area at the entrance pupil of the first optical integrator 3 is equivalent to the area of tertiary light sources 3a at the exit pupil of the optical integrator.

The optical integrator 3 is followed by a Fourier lens 4. The Fourier lens 4 superposes the light from the different secondary light sources 3a produced by the optical integrator 3. Optimum superposition and best irradiance uniformity is achieved in the Fourier plane 4a, located at z = ƒ_{FL} a focal length distance behind the Fourier lens 4. In the Fourier plane 4a, the angular distribution produced by the optical integrator translates into irradiance distribution. If the angular distribution produced by the secondary light sources 3a is a rectangular distribution in which all angles occur with the same irradiance, a perfectly uniform irradiance distribution 4b, also referred as Flat-Top or Top-Hat profile 4b is obtained in the Fourier plane 4a.

The first optical integrator 3 homogenizes the incident light such that a uniform irradiance in the Fourier plane 4a of the Fourier lens 4 is introduced independently from the incident irradiance and angular distribution. At each location on the optical integrator 3, light is distributed within a certain range of angles. This range may extend, for example, from -15° to +15°. The first optical integrator 3 thus slightly increases the geometrical optical flux and modifies the local irradiance distribution in a subsequent Fourier plane 4a.

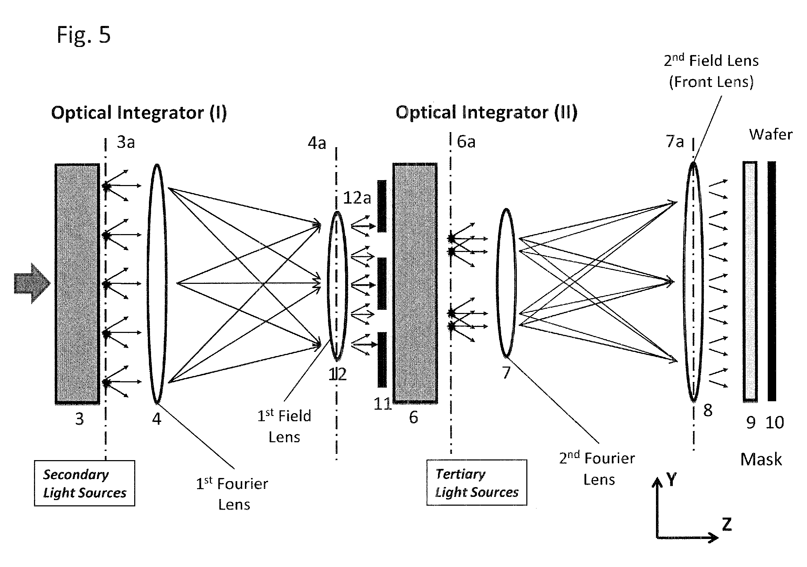

In one embodiment, shown schematically in Fig. 5, a first field lens 12 is located in the focal plane 4a of the first Fourier lens 4. Field lens 12 ensures telecentric illumination of the entrance pupil of the second optical integrator 6.

### b) Second Optical Integrator

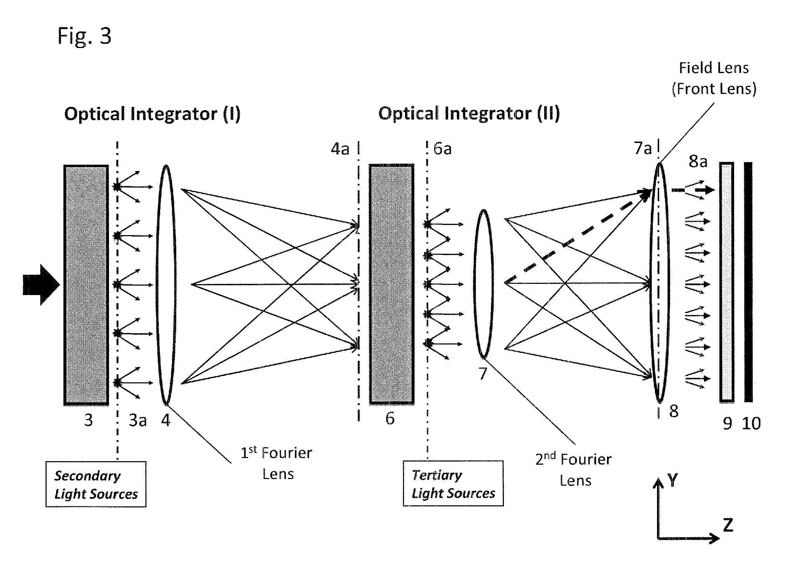

A second optical integrator 6, shown in more detail in Fig. 3, is located at the Fourier plane 4a of the first optical integrator 3. The second optical integrator 6 produces a plurality of tertiary light sources 6a each emitting a light bundle. The second optical integrator homogenizes the incident light such that a uniform irradiance in the Fourier plane 7a of the Fourier lens 7 is introduced. This means that at each location on the optical integrator element 6, light is distributed within a certain range of angles. For the second optical integrator 6 this range may extend, for example, from -5° to +5°. The second optical integrator 6 thus slightly increases the geometrical optical flux and modifies the local irradiance distribution in a subsequent Fourier plane 7a.

In general, the illuminated area at the entrance pupil of the second optical integrator 6 is equivalent to the area of tertiary light sources 6a at the exit pupil of the optical integrator.

A field lens 8 also referred as front lens 8, is located at the back focal plane 7a of the second Fourier lens 7 and collimates the illumination might. The field lens 8 ensures telecentric illumination 8a of the mask 9. In FIG. 3 telecentric illumination 8a is illustrated by rays drawn bold in broken lines. Telecentric illumination 8a ensures that the mask 9 is illuminated with light bundles with its central ray entering the mask plane perpendicularly. Transparent areas on the mask 9 transmit the light and illuminate the resist on the wafer 10, thus transferring the minute structures from the mask 9 to the wafer 10. Telecentric illumination 8a ensures that the lateral position of the mask pattern is transferred 1:1 to the wafer 10 with no lateral displacement.

### c) Angle Defining Elements

The angle defining element 5 comprises optical sub-elements and is located before, inside or after the second optical integrator 6. As discussed previously, the illuminated area 4a at the entrance pupil of the second optical integrator 6 is in general equivalent to the area of tertiary light sources 6a at the exit pupil of the optical integrator. Thus, the actual location of the angle defining element 5, before, inside or after the second optical integrator 6 has only minor influence on the position and lateral distribution of the tertiary light sources 6a.

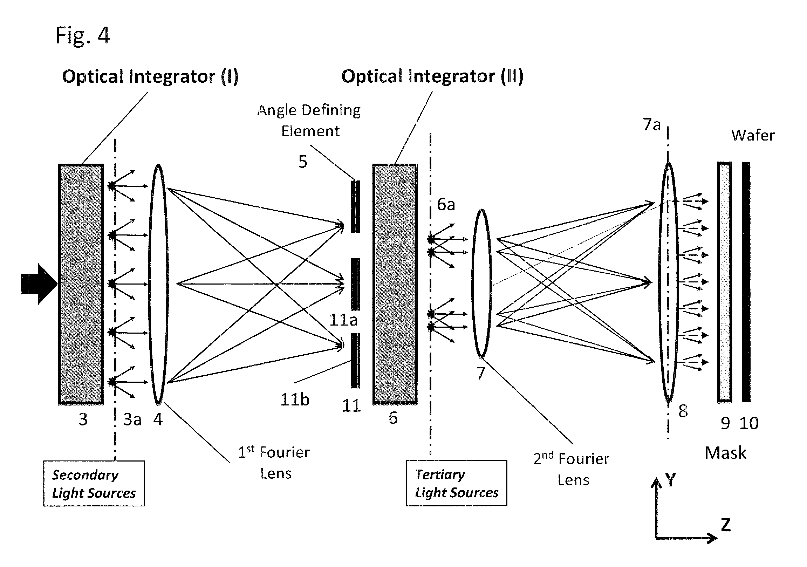

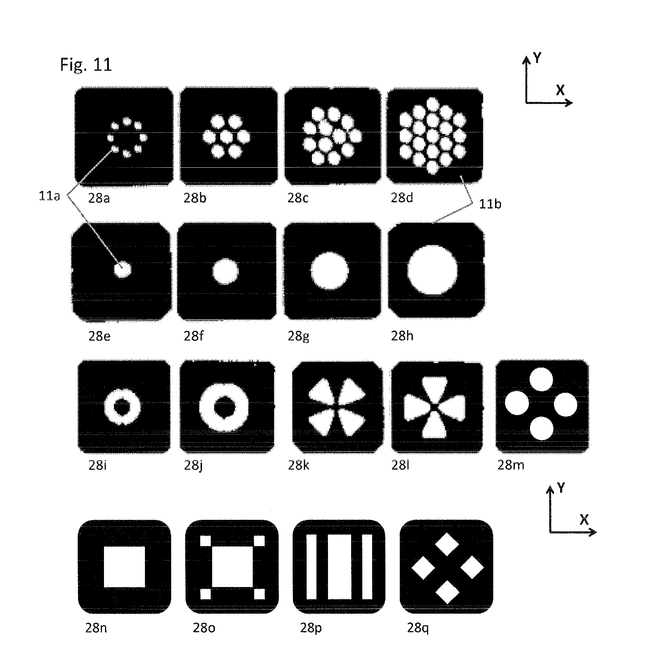

The angle defining element 5 defines the light emitting areas of tertiary light sources 6a at the secondary optical integrator 6. In one embodiment, shown in Fig. 4, the angle defining element 5 is a filter plate 11 with transparent 11a and opaque 11b areas. The filter plate 11 is typically located before the second optical integrator 6. Fig. 11 shows schematic views of angle defining elements 5 comprising different configurations of filter plates 11, comprising 28a-28d annular, 28e-28h circular, 28i and 28j ring, 28k-28l Maltese Cross shaped and 28m Quadrupole (45° tilted) and 28n-28q square and rectangular shaped transparent areas 11a. Transparent areas 11a define the areas where light passes the angle defining element 5 and after the second optical integrator 6 tertiary light sources 6a emit light bundles. The Fourier lens 7a and the field lens 8 transform the light from the tertiary light sources 6a into a telecentric illumination of the mask 9 with uniform irradiance and a defined angular distribution.

For the embodiment shown in Fig. 4, the pattern of transparent areas 11a on the angle defining element 11 correspond to the angular distribution of the illuminating light at the mask 9. For example, the angle defining element 28a shown in schematic drawing in Fig. 11, comprises 8 transparent circular areas 11a in the form of a ring. Thus the mask 9 is illuminated with ring illumination comprising 8 circular areas of tertiary light sources 6a.

The illustrations of Fig. 1 to 5, 11 are greatly simplified and not to scale. For example, the elliptical mirrors 2 typically has lateral dimensions of 100mm to 300 mm and the angle defining element 5 the dimension of 50mm to 100mm. It is to be understood that the configuration of the angle defining element 5 may be varied in various kinds. For example angle defining elements 5 might be transparent or semi-transpartent, they might comprise grey-level, refractive, diffractive, phase-shifting or Fresnel-type optical elements. Filter plates 11 might have transparent and opaque areas of any form, they might be non-symmetric or might have any other 3-dimensional form or material providing desired distribution of the tertiary light sources 6a.

### 2.1 Optical Integrators using Lens Arrays

### a) Optical Integrators using Two-Dimensional Arrays

The optical integrators 3, 6 shown in Fig. 1-5 comprise optical sub-elements and produce a plurality of secondary light sources 3a, 6a each emitting a light bundle with ideally a similar angular distribution.

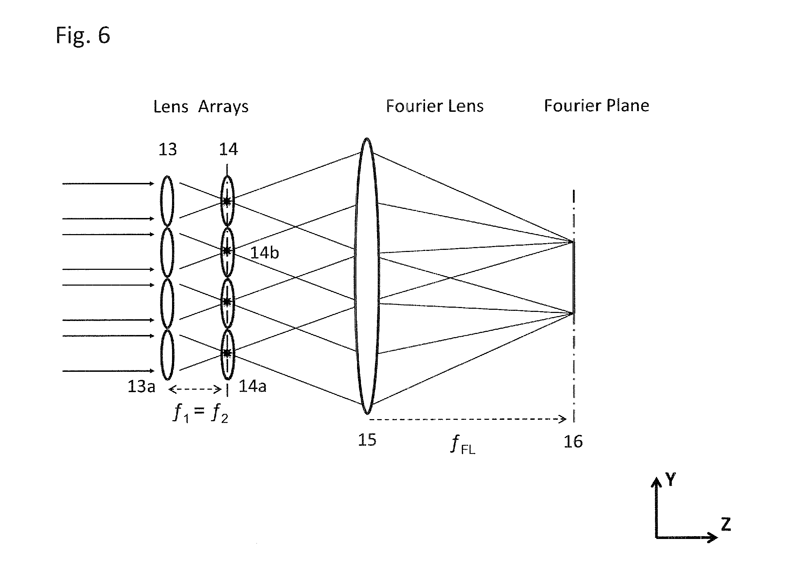

In one embodiment shown in Fig. 6, known as such from International Applications US 1'762'932 and US 2'186'123, the optical integrator comprises a first integrator member 13 and a second integrator member 14. The first integrator member 13 comprises a first array of lenses 13a having a positive refractive power. The second integrator member 14 is an identical copy of the first integrator member 13.

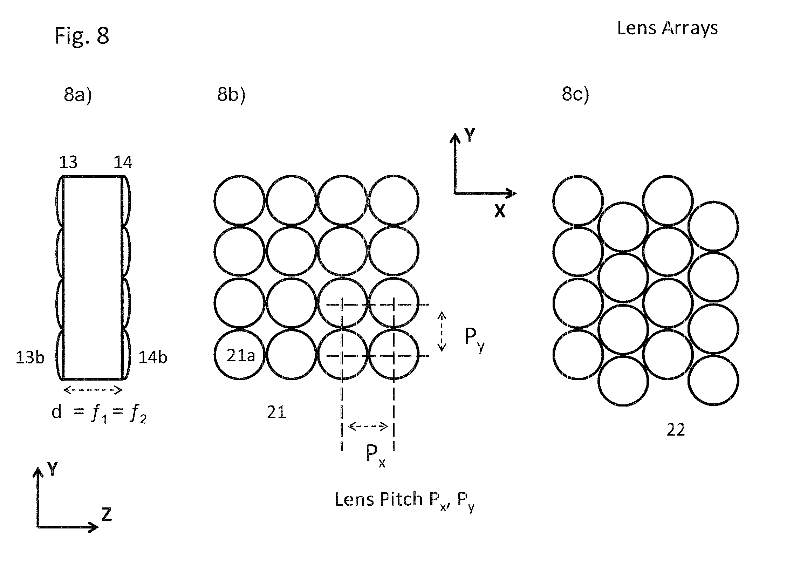

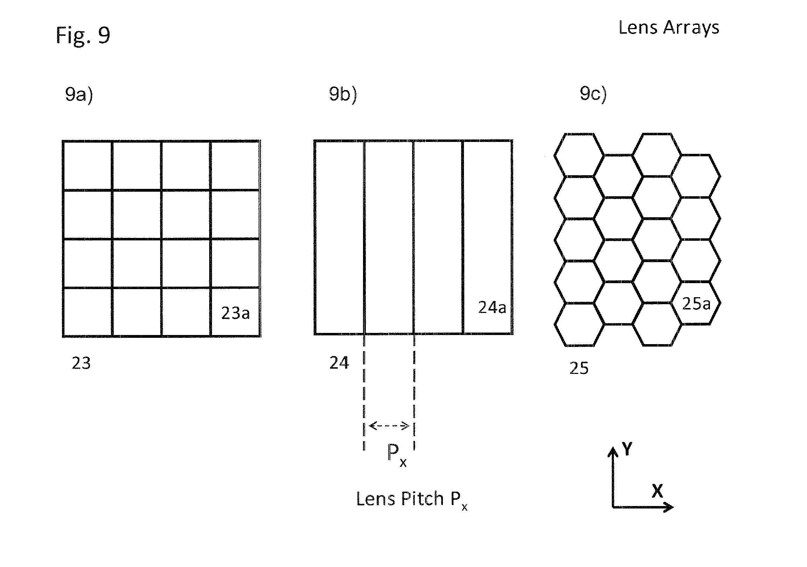

Lens arrays 13a and 14a comprise a plurality of - usually periodically arranged - sub-elements, for example circular lenses, cylindrical lenses, square lenses, rectangular lenses, hexagonal lenses, free-form and randomly shaped lenses. Lenses 13a, 14a comprise refractive and diffractive optical elements, diffuser plates, and glass rods or fibers with optical power. Fig. 8 shows b) a schematic view of a regular packed array 2i and c) a hexagonal packed array 22 of circular lenses. Fig. 9 shows a) a regular packed array 23 of quadratic lenses 23a; b) a one-dimensional array 24 of cylindrical lenses 24a; and c) a hexagonal packed array 25 of hexagonal lenses 25a.

As shown in Fig. 6, the focal lengths f₁ and f₂ and the distance between the integrator members 13, 14 are selected such that the focal points of an incident plane wafer focused by the first lenses 13a are located on the vertices of the second lenses 14a. Since the second lenses 14a have the same focal length f₂, this implies that the focal plane of the lenses 14a is located on the vertices of the first lenses 13a. In this embodiment, the number of illuminated sub-elements on integrator member 13 is approximately equivalent to the number of secondary or tertiary light sources 3a each emitting a light bundle with ideally a similar angular distribution after the optical integrator. Thus, by shaping the entrance pupil of the optical integrator the number of secondary or tertiary light sources 14b is modified. In some embodiment the focal lengths ƒ₁ of the first array of lenses 13a might be shorter or longer than the focal lengths ƒ₂ of the second array 14a. In some embodiment the array of lenses 13a, 14a comprise individual lenses with equal dimensions 17a to 20a, 21a, 23a, 24a, 25a and focal length, in others the arrays are combined by lenses of different dimensions and focal length. However, in general the first array 13a is always located in or near the front-focal planes of the second array 14a.

### b) Optical Integrators using One-Dimensional Arrays

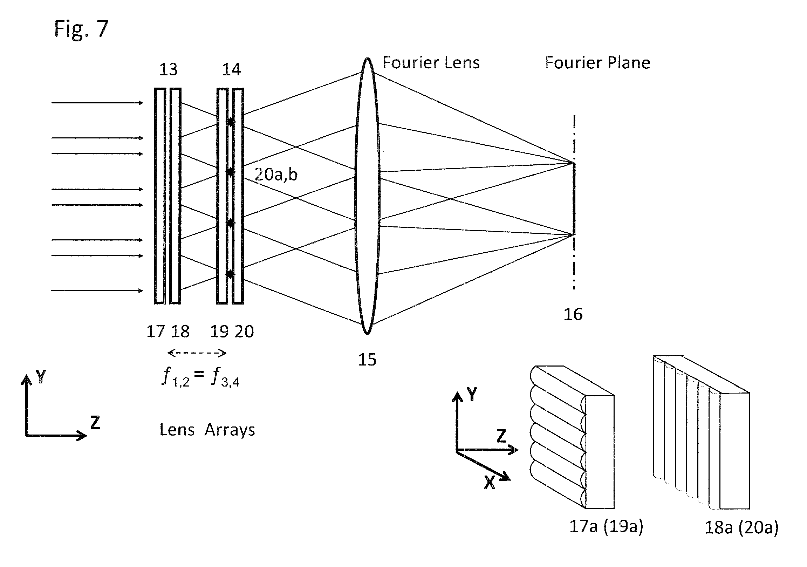

In one embodiment shown in Fig. 7, the optical integrator comprises a first integrator member 13 and a second integrator member 14 comprising a total of four cylindrical lens arrays 17-20 as shown in Fig. 9b. The first integrator member 13 comprises a first array of lenses 17a, having parallel longitudinal axes that are aligned along the X direction. Thus the first lenses 17a have a positive refractive power only in the Y direction with a back focal length f₁. The first integrator member 13 further comprises an array of second cylindrical lenses 18a that have parallel longitudinal axes aligned along the Y direction. The second lenses 18a have a positive refractive power only in the X direction with a back focal length f₂ = f₁.

The second integrator member 14 is an identical copy of the first integrator member 13, thus third lens array 19 is identical to first lens array 17 and fourth lens array 20 is identical to third lens array 18.

As can be seen in Fig. 7, the focal lengths f₁, f₂,f₃ and f₄ are identical and the distance between the integrator members 13, 14 are selected such that focal lines produced by the first and second lenses 17 and 18 are located on the vertices of the third and fourth lenses 19 and 20 respectively. Since the third and fourth lenses 19 and 20 have the same focal length f₃ = f₄, this implies that the focal lines of the third and fourth lenses 19 and 20 are located on the vertices of the first and second lenses 17 and 18 respectively.

### c) Optical Integrators using Monolithic One- or TWO-Dimensional Arrays

In Fig. 7 the lens arrays 17, 18, 19 and 20 are represented as sub-elements 17a, 18a, 19a and 20a that have one plane surface. However, the integrator members 13, 14 will usually not be assembled from separate sub-elements, but will be manufactured in a more efficient way, for example by manufacturing lens arrays on both sides of a substrate as shown schematically in Fig. 8a.

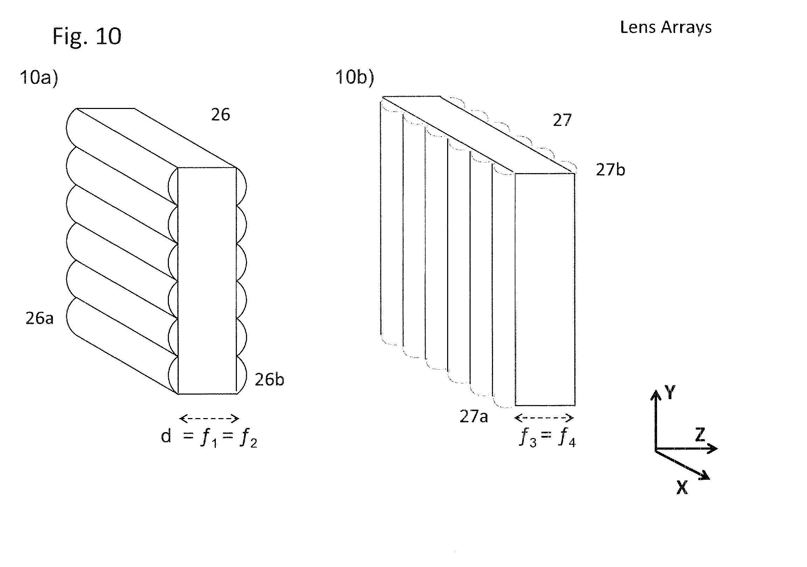

Fig. 10a shows a schematic drawing of two identical arrays of cylindrical lenses 26a and 26b located on the front- and backside of a planar substrate. First array of lenses 26a, having parallel longitudinal axes that are aligned along the X direction. Thus the first lenses 26a have a positive refractive power only in the Y direction with a back focal length f₁. A second lens array of cylindrical lenses 26b that have parallel longitudinal axes aligned along the X direction is located on the backside of the substrate 26. The second lenses 26b have a positive refractive power only in the Y direction with a front focal length f₂ = f₁. The thickness d of the substrate 26 is corresponds to the focal length d = f₁ = f₂ to ensure that the focal lines of lenses 26a are located on the vertices of lenses 26b and front focal lines of 26b are located on the vertices of lenses 26a. Thus the optical integrator member 13 as shown in Fig. 7 consists of a monolithic lens array 26 providing homogenization in X direction.

In one embodiment, the second integrator member 14 is an identical copy of the first integrator member 13 shown in Fig. 10a, but is mounted after a rotation by 180° around the Z axis as shown in Fig. 10b. Thus optical integrators comprising two monolithic lens arrays 26 and 27, comprising four arrays of cylindrical lens 26a, 26b, 27a, 27b produces a plurality of secondary light sources 3a each emitting a light bundle having the same angular distribution.

In another embodiment, shown in Fig. 8a, the optical integrator comprises monolithic arrays of identical two-dimensional lens arrays 13, 14 on the front- and backside of planar substrate. In this embodiment, the first optical integrator member 13 corresponds to a two-dimensional array of lenses 13b of different forms 21, 22, 23, 25 as shown in Fig. 8 and 9. Thus the first lenses 13b have similar positive refractive power in the X and Y direction with a back focal length f₁.

The thickness d of the substrate d is corresponds to the focal length d = f₁ = f₂ to ensure that the focal points of lenses 13b are located on the vertices of lenses 14b and front focal points of 14b are located on the vertices of lenses 13b. Thus as shown in Fig. 8a, the optical integrator members 13 and 14 are combined in a monolithic double-sided lens array providing homogenization in both X and Y direction.

In some embodiment the focal lengths ƒ₁ of the front-side arrays of lenses 26a, 27a might be shorter or longer than the focal lengths ƒ₂ of the arrays 26b, 27b on the back-side. In some embodiment the array of lenses 26a, 26b, 27a, 27b comprise individual lenses with equal dimensions 17a to 20a, 21a, 23a, 24a, 25a and different focal lengths, in others the arrays are combined by lenses of different dimensions and focal length. However, in general the front-side arrays 26a, 27a are always located in or near the front-focal planes of the back-side arrays 26b, 27b.

### d) General Remarks on Lens Arrays used for Optical Integrators

The technology used for manufacturing the optical integrator members 13, 14 also depends on the pitch P of the lens arrays 13a, 13b, 14a, 14b, 17a, 18a, 19a, 20a, 21-25 which may be in the range of some hundred microns to several millimeters. The pitch P generally denotes the width of lenses of a lens arrays along the direction in which it has a refractive power. In the case of a cylinder lens, the pitch is equal to the dimension of the microlens perpendicular to its longitudinal extent.

From these remarks it becomes clear that the illustrations of Figs. 6 to 10 are greatly simplified and not to scale. For example, if the integrator members 13, 14 have lateral dimensions of 50 mm and the pitch of the lens arrays equals 500 µm, each array will be made up of 1'000'000 lenses or microlenses. It is to be understood, however, that the pitch and the number of cylindrical lenses 17a, 19a, 26 having a refractive power in the X direction do not have to be equal to the pitch and number of the cylindrical lenses 18a, 20a, 27 having a refractive power in the Y direction.

It is to be understood that the configuration of the optical integrator may be varied in various kinds. For example, the lenses 13a, 13b, 14a, 14b, 17a, 18a, 19a, 20a, 21-25 may be concavely or aspherically shaped. Aspherical lenses may be used, for example, for achieving special non-uniform irradiance distributions on the mask 9, for example distributions in which the irradiance at the edges is slightly higher than in the centre.

Apart from that it is also contemplated to use diffractive optical elements instead of the refractive lenses for achieving refractive power in the X and/or Y direction.

### 2.2 Alternative Arrangements of Optical Integrators

### a) Light guiding Rod with Variable Mirror Tube

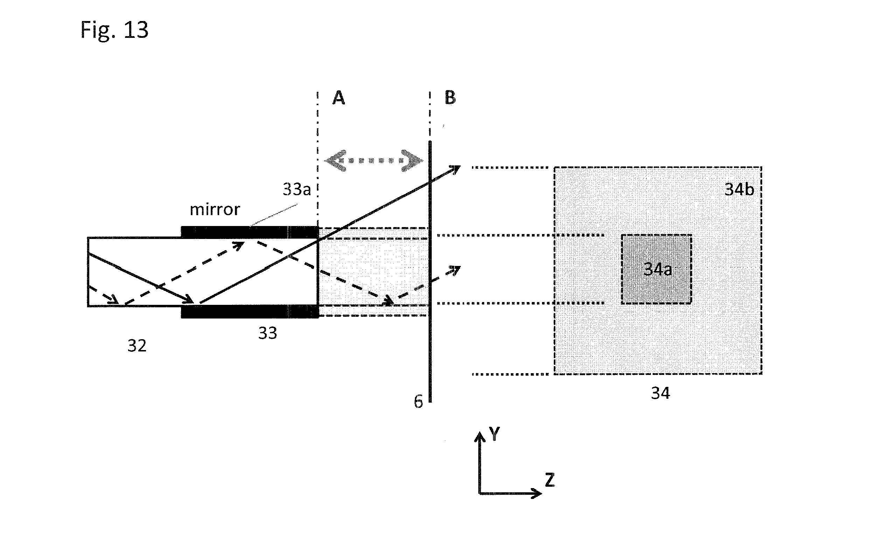

In the following, various alternative arrangements of optical integrator 3 will be described with reference to Fig. 1 to 5. In one embodiment, shown in Fig. 13, a light guiding glass rod 32, also referred as light mixing rod or Kaleidoscope is used as first optical integrator. Light from the collector 2 is focused to the entrance pupil of the glass rod 32, guided inside the rod by reflection on mirror surfaces or by total internal reflection at glass surfaces and exits the rod at the exit pupil. The light mixing properties of light guiding rods 32 or Kaleidoscopes are well known and will not be explained in further details. Light guiding rods 32 are frequently used as optical integrators providing a mixing and homogenizing of light from a light source 1.

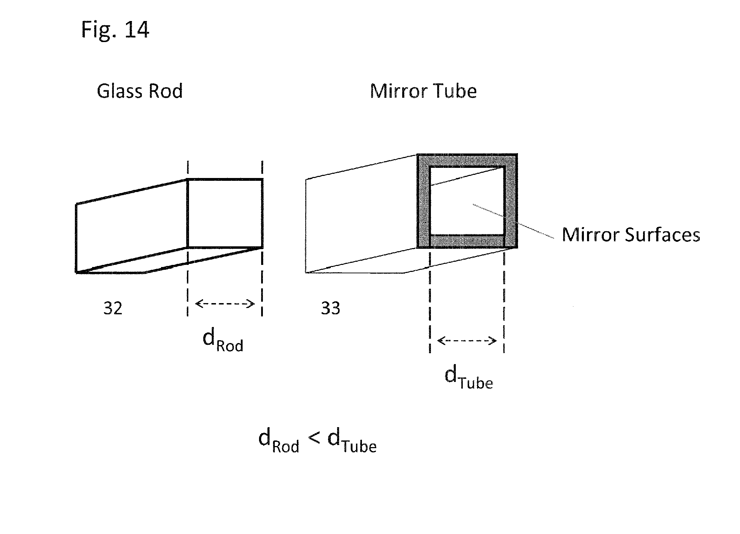

In one embodiment, shown in a schematic drawing in Fig. 13 and Fig. 14, the light guiding rod 32 is combined with a variable mirror tube 33. The variable mirror tube is located around the light guiding glass rod 32. The tube 33, for example a quadratic tube comprising reflective mirrors at the inner surfaces shown schematically in Fig. 14, preferably has inner dimensions d_{Tube} slightly larger than the outer dimensions of the light guiding rod 32, i.e. d_{Tube} > d_{Rod}, to allow moving the tube 33 forward and backward from minimum position "A" to maximum position "B" indicated in Fig. 13. In Fig. 13, position "A" marks the Z position where the mirror tube 33 does not exceed the glass rod 32 and therefore has no influence on the light exiting the glass rod 32. In Fig. 13, position "B" marks the Z position where the mirror tube 33 is in contact with the subsequent second optical integrator 6.

If the tube 33 is located at position "A", the light exiting the exit pupil of the glass rod 32 will propagate and illuminate a larger area 34b in entrance pupil of the subsequent second optical integrator 6. If the tube 33 is located at position "B", the light exiting the exit pupil of the glass rod 32 will be reflected at mirrors inside the mirror tube 33 and will illuminate a smaller area 34a in entrance pupil of the subsequent second optical integrator 6. In general, the illuminated area 34 on the second optical integrator 6 varies with the actual Z position of the mirror tube 33. A change of the size of the illuminated area 34 implies with a change of the number of illuminated lens channels of the optical integrator member 13 and therefore changes the number and position of the tertiary light sources 6a.

### b) Apodization at Second Optical Integrator

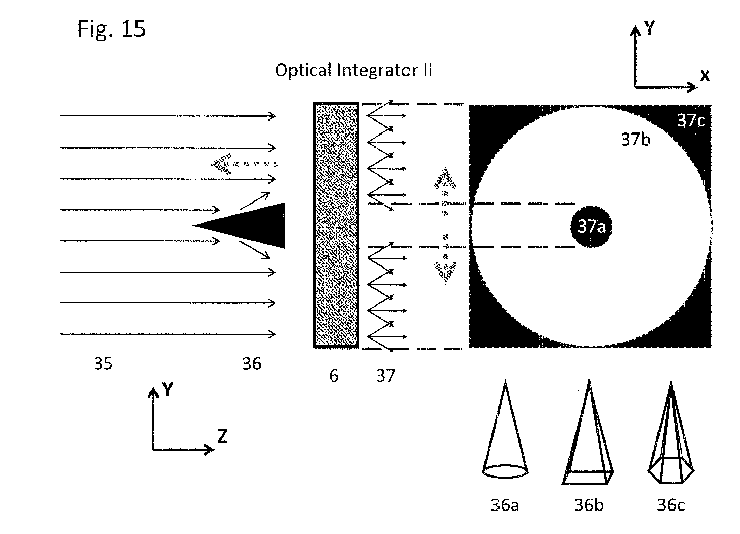

In the following, various alternative arrangements of optical integrator 6 will be described with reference to Fig. 1 to 5. Fig. 15 shows a meridional and considerably simplified view of an optical integrator 6 comprising an absorbing or reflecting axial-symmetric element 36 located before the entrance pupil of the second optical integrator 6. Blocking or redirecting the central part of an optical element is referred as apodization. Blocking of the incident light in the center of the second optical integrator 6 corresponds to a dark circular area 37a behind the second optical integrator 6, where no tertiary light sources exist, as shown in top view in Fig. 15. The shape of the dark area 37a corresponds to the shadow of the optical element 36. For example a cone with a circular base 36a corresponds to a circular dark area 37a as shown schematically in Fig. 15.

In one embodiment the element 36 is absorbing, in another embodiment the element 36 is reflective and redirects the incident light into the entrance pupil of the second optical integrator 6. The possible forms of the axial-symmetrical element 36 comprises a variety of different shapes, amongst them a cone 36a, a pyramid 36b and a cone with hexagonal base 36c, corresponding to a circular, quadratic or hexagonal dark area 37a in the exit pupil of the second optical integrator 6. The possible forms of the axial-symmetrical element 36 comprises as well all kind of reflective optics referred as Schwarzschild objectives.

Moving the optical element 36 in -Z direction will increase the size of the inner dark area 37a at the exit pupil of the second optical integrator 6.

### c) Light Guiding Rod with Variable Mirror Tube and Apodization at Second Optical Integrator

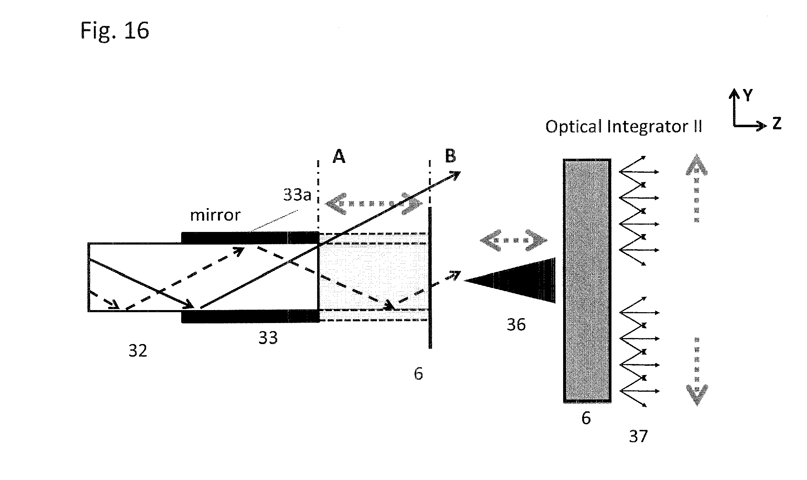

Fig. 16 shows a combination of the light guiding rod 32 with variable mirror tube 33 as described in Fig. 13 and Fig. 14 and a variable absorbing or reflecting element 36 as described in Fig. 15. Moving the variable mirror tube 33 in -Z direction will increase the size of the will increase the size of the outer boundaries 34b of the illuminated area on the optical integrator and reverse. Moving the optical element 36 in -Z direction will increase the size of the inner dark area 37a at the exit pupil of the second optical integrator 6 and reverse.

### 3.0 Alternative Arrangements of Collector

### a) Collector Comprising One Hemispherical Mirror and Two Half Ellipsoids

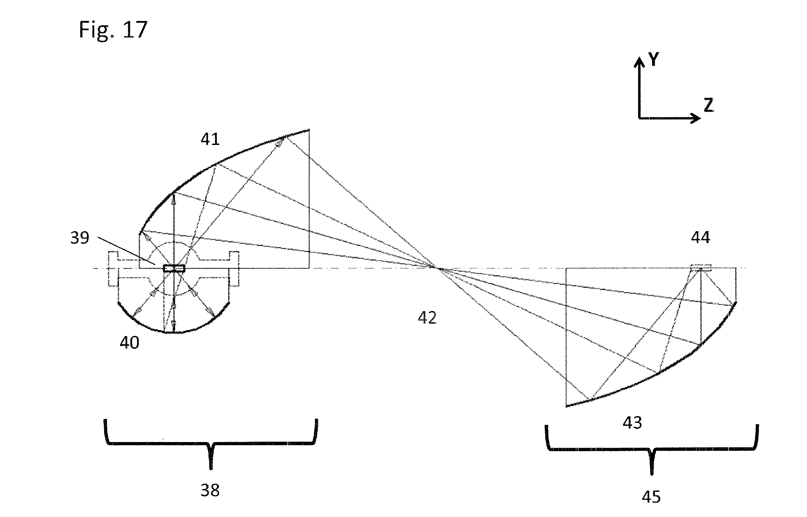

In the following, an alternative arrangement of collector 2 will be described with reference to Fig. 1. FIG. 17 is a meridional and considerably simplified view of a collector comprising two collector members 38, 43. Collector member 38 consists of a hemispherical mirror 40 and half ellipsoid 41. One part of the light emitted by the lamp 39 is reflected back by a hemispherical mirror 40 as shown schematically in Fig. 17. A half ellipsoid 41 collects the light from the lamp 39 and back reflected light from the hemispherical mirror 40. The lamp 39 is preferably located in the primary focal point of the elliptical mirror 41, thus, a converging light bundle with a secondary focal point 42 is obtained. A second half ellipsoid 43, preferably identical to first half ellipsoid 41, is located in the diverging light bundle behind focal point 42, collects the light and produces a secondary focal point 42.

In one embodiment the half ellipsoids 41 and 43 are arranged symmetrically versus a common focal or symmetry point 42 as shown in Fig. 17. In this embodiment the secondary focal point 44 is an image of the lamp 40, imaged by the hemisphere 40 and the half ellipsoids 41 and 43.

Elliptical 2 and half elliptical mirrors 41 provide perfect imaging of a point source located in the primary focal point 1, 39 to a secondary focal point 2a, 42 respectively. However, elliptical 2 and half ellipsoidal mirrors 41, 43 show severe aberrations for imaging any other points than primary or secondary focal points. Thus extended light sources 39, as shown in Fig. 17, will produce an aberrated focal point 42. For light sources 1-2 as used for microlithographic contact and proximity exposure apparatus of present invention and shown schematiccally in Fig. 1, the size of light emitting arc 1 is typically some 1mm to 5mm. The focal spot 2a obtained by an elliptical collector is typically on the order of 20mm to 50mm diameter. In symmetric arrangement of the two collector members 41, 43, shown schematically in Fig. 17, aberrations produced by the first half ellipsoid 41 are compensated by the inverse aberrations produced by the second half ellipsoid 43. In this embodiment the dimensions of images 2a, 44 of the light source 1, 39 is on the same order as the light source 1, 39 itself, thus approximately 10 times smaller. A smaller light source 2a, 44 results in a smaller area 2a of incident light at the first optical integrator 3, provides a significantly smaller angular spectrum after lens 4, and allows illuminating a smaller area of the angle defining elements 5 with no loss of light. The described embodiment is preferred for angle defining elements with a condensed distribution of transparent areas, like for example 28a, 29a, 30a, providing a uniform illumination of the mask 9 with small angular distribution.

### b) Collector Comprising Two Ellipsoids and Light-Redirecting Elements

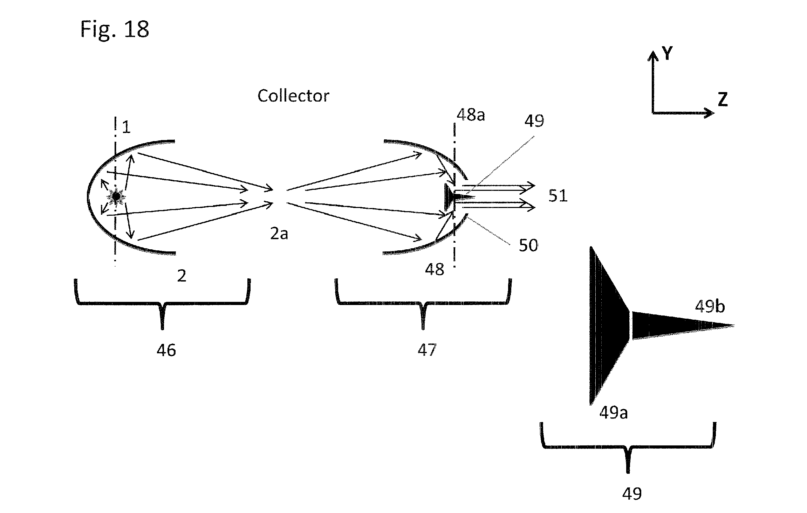

In the following, an alternative arrangement of collector 2 will be described with reference to Fig. 1. FIG. 18 is a meridional and considerably simplified view of a collector comprising two collector members 46, 47. Collector member 46 consists of an elliptical mirror 2 as shown in Fig. 1. Collector member 47 consists of an elliptical mirror 48, preferably identical to the elliptical mirror 2, but rotated 180° around the Y axis; and a redirecting element 49. Preferably the second focal point 2a of the first elliptical mirror 2 is identical to the first focal point of the second elliptical mirror 48. Thus, symmetric arrangement of the two collector members 46, 47 significantly improves imaging of the light source 1 to the secondary focal point 48a of elliptical mirror 48.

In one embodiment, a light-redirecting element 49, as shown schematically in Fig. 18, is located at the second focal point 48a of the second elliptical mirror 48 and redirects the light 51 in Z direction, out of a circular opening 50 in the second elliptical mirror 48. Radial-symmetrical redirecting elements 49, shown schematically in Fig. 18, comprise typically two sub-elements 49a, 49b with different angles. In one embodiment, the light-redirecting element 49 is reflective.

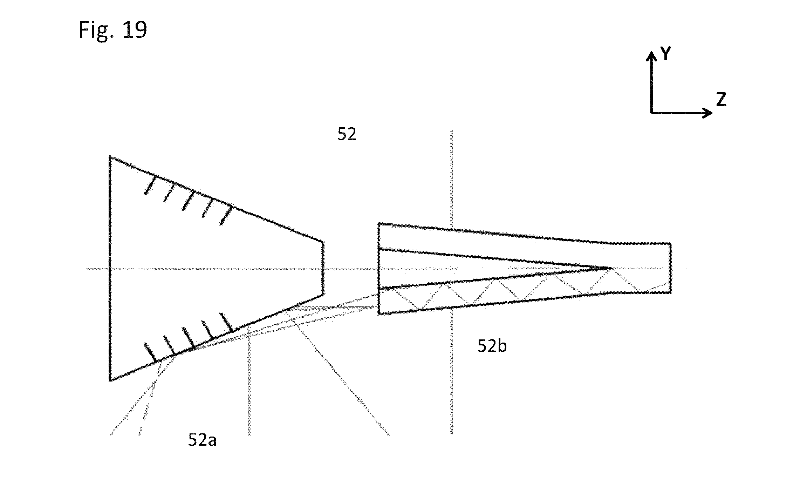

In another embodiment, shown schematically in Fig. 19, the redirecting element 52 comprises a reflective sub-element 52a and a light guiding sub-element 52b.

The illustrations of Fig. 18, 19 are greatly simplified and not to scale. For example, the elliptical mirrors 2 and 48 typically have lateral dimensions of 100mm to 300 mm and the redirecting element 49, 52 some 5mm to 30mm. It is to be understood that the configuration of the optical collector may be varied in various kinds. For example the redirecting elements 49, 52 might have a pyramidal form, might be non-symmetric or might have any 3-dimensional form providing desired redirection of the light at the second focal point 48a.

### 4.0 Alternative Arrangements of Angle Defining Elements a) Variable Angle Defining Elements

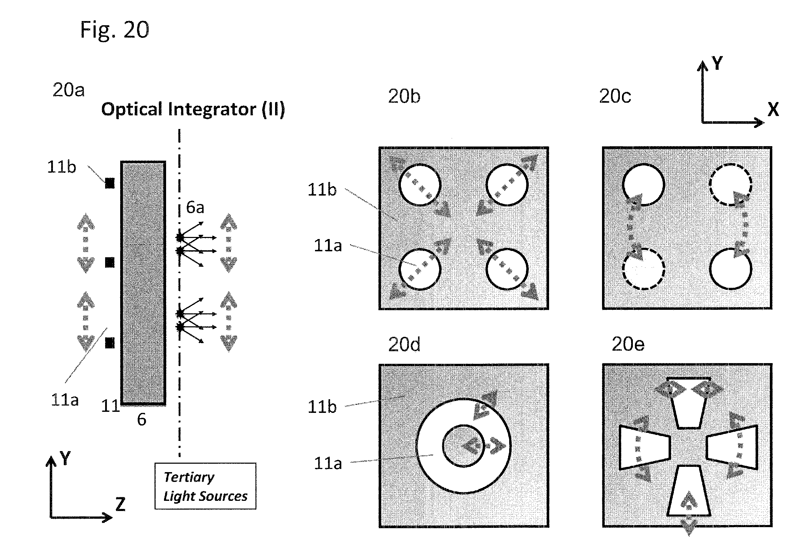

In one embodiment, shown schematically and significantly simplified in Fig. 20, the angle defining element 11 comprises different types of variable angle defining elements 11 allowing a change of the position and dimensions of transparent and opaque areas. Variable angle defining elements include, but are not necessarily limited to liquid crystal displays (LCD), micro-mirror arrays (DLP), variable membranes (MEMS, MOEMS), spatial light modulators (SLM) and light deflectors, acusto-optical modulators and deflectors, variable diaphragms, and all kind of mechanics suitable to move, rotate and change the shape of apertures.

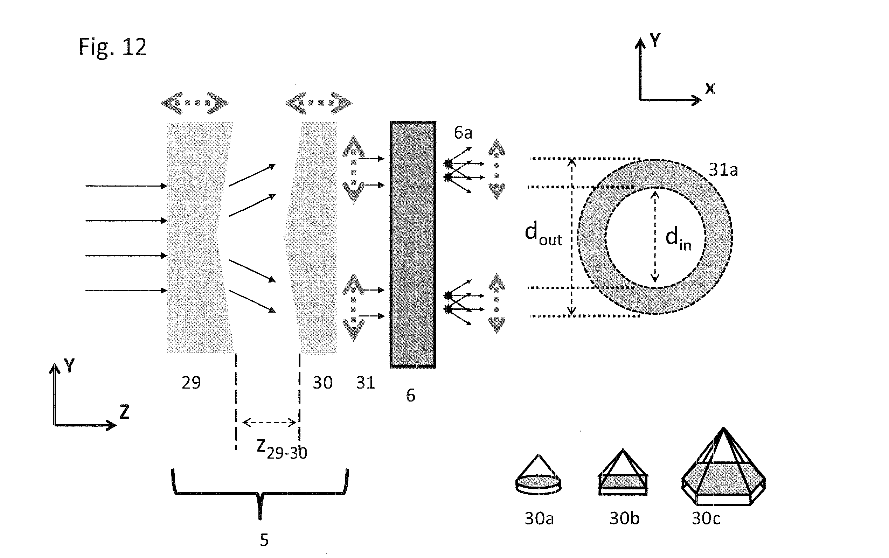

In one embodiment, shown in Fig. 12 the angle defining element 5 comprises two sub-elements 29, 30, whereas one surface of the first sub-element 29 is preferably concave and one surface of the second sub-element 30 is preferably convex. The sub-elements include, but are not necessarily limited to axicons (30a), pyramidal elements (30b, 30c), refractive lenses, diffractive optical elements or holograms. Angle defining elements 5 using sub-elements 29, 30 comprising a plano-convex 30a and plano-concave axicon are referred as axicon telescope. Axicon telescopes illuminated with a plane wave redirect the incident light in an ring-shape light distribution 31 at its exit pupil providing apodization with no light within an inner ring of dᵢₙ diameter.

The Z-position of one or both sub-elements 29, 30 is variable. As shown schematically in Fig. 12 a change of the distance Z₂₉₋₃₀ changes the inner and outer diameter of the ring illumination 31a exiting the angle defining element shown in Fig. 12 as top view.

The illustrations of Fig. 20 and Fig. 12 are greatly simplified and not to scale. For example, the dimensions of said sub-elements in Fig. 12 are typically 50mm to 100mm, whereas the height difference at the center and rim (sag) is on the order of 5mm to 20mm. It is to be understood that the configuration of the variable angle defining elements 5 may be varied in various kinds. For example the said sub-elements 29, 30 might have a pyramidal form with variation of different bases, might be non-symmetric or might have any other 3-dimensional form providing desired reaction of the light to larger angles.

### b) Flexible light Guides as Secondary Light Sources

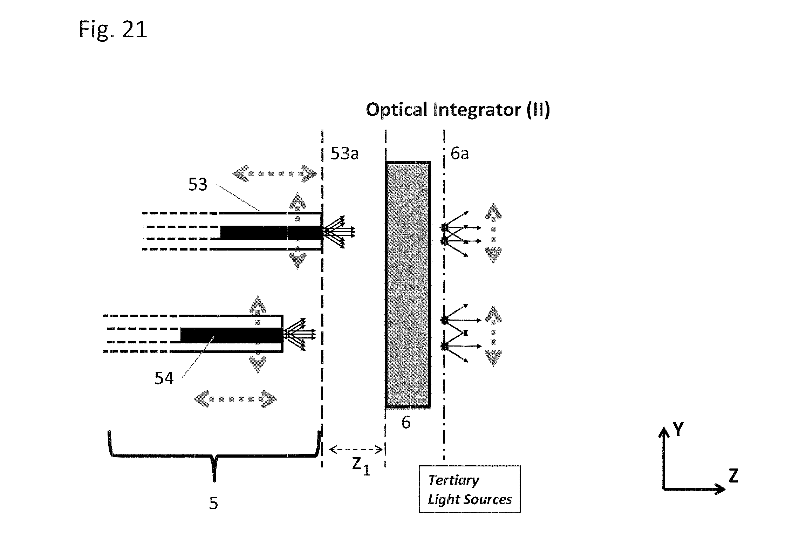

Fig. 21. shows (a) a meridional and considerably simplified view of a part of a microlithographic contact and proximity exposure apparatus in accordance with the present invention, where lamp 1, collector 2 and first optical integrator 3 are replaced by an angle defining element 5 comprising one, two or multiple flexible light guides 53 replacing the lamp 1, collector 2 and first optical integrator 3. The flexible light guides 53 typically comprise a core 54, where the light is guided from one or multiple light sources to the exit plane 53a. Thus, flexible light guides 53 serve as secondary light sources and emit light. The exit window of one or multiple flexible light guides are located at certain distances zₙ in front of the second optical integrator 6.

The expression light-guide include, but is not necessarily limited to liquid light guides, fiber-bundles, fiber-plates, flexible or rigid rods, or any other light-guiding structure that transports light from one or multiple light-sources to another plane 53a. The dimensions and form of the light guiding core 54, the emitted angular spectrum, the position X,Y,Z of the individual light guides to the second optical integrator 6 might vary. In one embodiment the position of different light guides is even varied during one exposure cycle to vary the angular distribution of the illumination light 8a impinging the mask 9.

### c) Light Guides as Secondary Light Sources and Apodization at Second Optical Integrator

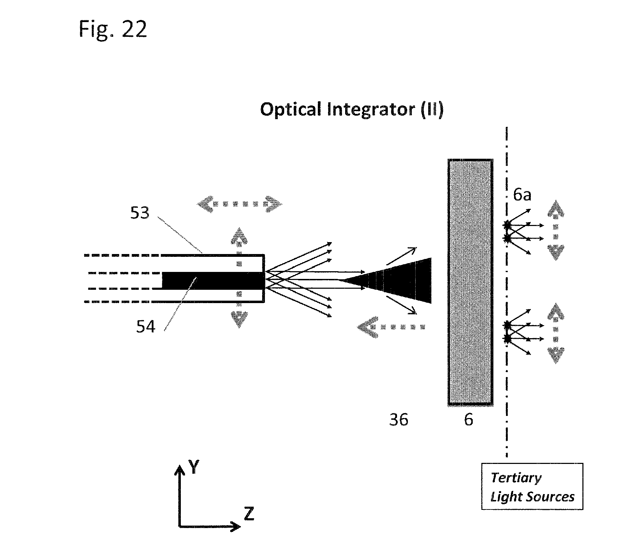

Fig. 22 shows a combination of a light guide rod 53 with variable X,Y,Z position as described in Fig. 21 and a variable absorbing or reflecting element 36 as described in Fig. 15. Moving the flexible light guide 53 in -Z direction will increase the size of the illuminated area on the entrance window of the second optical integrator 6. Moving the optical element 36 in -Z direction will increase the size of the inner dark area at the entrance pupil of the second optical integrator 6.

### d) LEDs as Secondary Light Sources at Second Optical Integrator

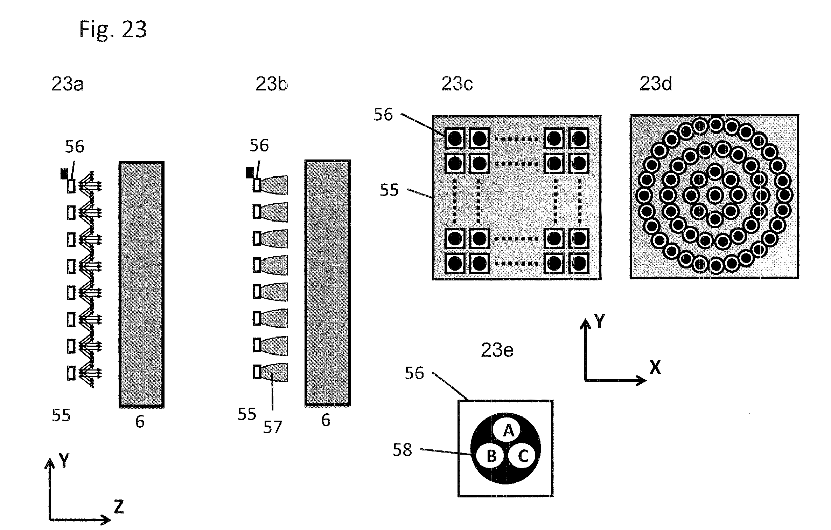

Fig. 23 shows (a) a meridional and considerably simplified view of a part of a microlithographic contact and proximity exposure apparatus in accordance with the present invention, where lamp 1, collector 2 and first optical integrator 3 are replaced by an angle defining element 5 comprising an electronic board 55 and multiple UV-LEDs 56 or (b) an electronic board 55, multiple-LEDs 56 and collimation optics 57, both located at the second optical integrator 6. Fig. 23 (c) to (d) are top-views of an angle defining element 5 with UV-LEDs 56 arranged in (c) a regular pattern, (d) in a angular pattern on the electronic board 55. Fig. 23 (e) is a top-view of an sub-element of (c) and (d), whereas said UV-LED 56 comprise one or more sub-LEDs emitting light of one or different wavelengths indicated in the drawing by letters A to C.

Angle defining elements 5 as shown in Fig. 23 comprise a flexible control of the individual LEDs 56 allowing to vary the intensity and wavelength of the emitted light, thus allowing a flexible change the angular spectrum 6a and wavelengths emitted by the second optical integrator 6.

The illustrations of Fig. 23 are greatly simplified and not to scale. For example, the dimensions of a said LED 56 are typically 1mm x 1mm to 5mm x 5mm, whereas the lateral dimensions of the electronic board 55 are typically on the order of 50mm to 100mm. It is to be understood that the configuration of the variable angle defining elements 5 may be varied in various kinds. For example the said expression LED 56 might include, but not necessarily limited to UV-LEDs, VCSELs, Organic LEDs or other similar type of semiconductor based light sources. It is also to be understood that distribution of the LEDs 56 on the electronic board 55 is not limited to the configurations shown in Fig. 23 (c) and (d), might be non-symmetric or might have any other 2-dimensional distribution that is suitable to provide a desired angular distribution 8a at the mask 9.

### 5.0 Alternative Positions and Arrangements of Second Fourier Lens to Provide Run-Out Control

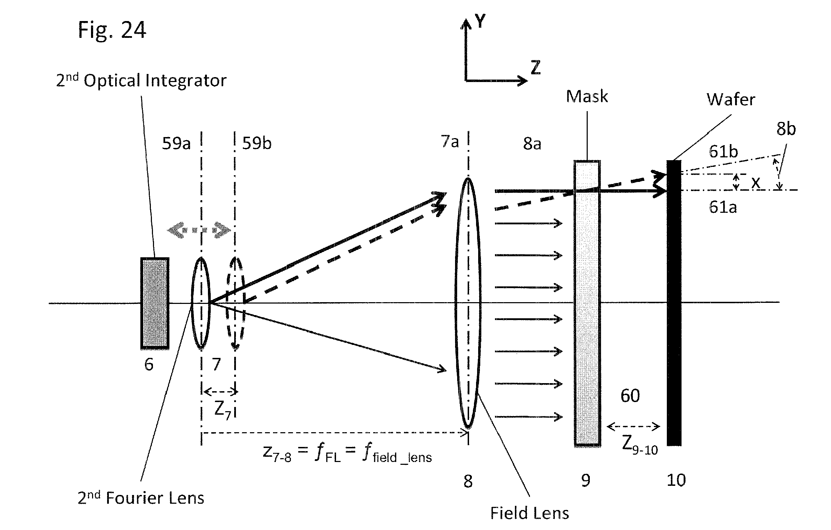

Fig. 24 is a meridional and considerably simplified view of a part of a microlithographic contact and proximity exposure apparatus in accordance with the present invention, where the position 59a of the second Fourier lens 7 is variable to change the degree of collimation behind the second field lens 8. In one embodiment, shown schematically in Fig. 24, the focal length f_{FL} of the second Fourier lens 7 is equal to the focal length f_{field_lens} of the second field lens 8 and equal to the distance z₇₋₈ from the Fourier lens 7 to the field lens 8. In this embodiment the principle rays passing the center of the second Fourier lens 7 are perfectly collimated by the field lens 8 and enter the mask with perpendicular incidence. In this embodiment a shift z₇ of the Fourier lens 7 in Z-direction results in a diverging light bundle after the second field lens 8, a shift z₇ of the Fourier lens 7 in -Z-direction results in a converging light bundle after the second field lens 8. Thus, a shift z₇ of the Fourier lens 7 introduces a change of the angles 8b of the principle rays of the illumination light 8a impinging at the mask 9. For proximity printing a variation of the angle 8b of the mask illuminating light 8a is introduces a change of the lateral dimensions of the printed pattern on the resist layer of the wafer in proximity printing (run-out control).

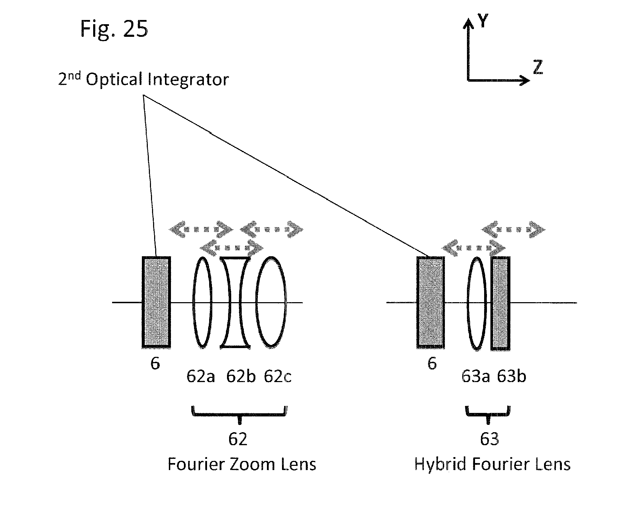

As shown in Fig. 24 by bold broken lines a shift z₇ of the Fourier lens 7 position 59a to a position 59b introduces a sleight tilt 8b of the principle rays impinging the mask 9. For proximity printing, whereas the wafer 10 is located at a distance z₉₋₁₀ of typical 1 micron to 500 microns behind the mask 9, a tilt 8b of the illuminating light introduces a lateral shift x from position 61a to position 61b of the printed miniature structure in the resist layer on the surface of the wafer 10. The introduced lateral shift x is zero at the center of the wafer and takes a maximum value at the rim of the wafer. As shown in Fig. 25 the Fourier lens 7 might be replaced by a Fourier zoom lens 62 or a hybrid Fourier lens 63.

Fourier zoom lenses 62 includes a combination of different refractive lenses, hybrid Fourier lenses 63 include, but are not necessarily limited to a combination of lenses, diffractive optical elements, holographic elements, radial gratings, linear gratings, axicons or axicon telescopes, prisms, or prism arrays; whereas both 62, 63 act as Fourier lenses similar to Fig. 2 and superpose the light from the different tertiary light sources 6a in one plane 7a. Both, Fourier zoom lens 62 and hybrid Fourier lens 63 provide optimum superposition and best irradiance uniformity in a Fourier plane 7a, located at the position of the field lens 8, however, they also provide a tilt 8b of the principle rays impinging at the mask 9. In both arrangements 62, 63 the Z-position of at least one sub-elements is variable to change the optical properties resulting in a change of the tilt 8b and the lateral position 61a to 61b in the resist layer on the wafer 10.

### 6.0 Alternative Positions and Arrangements of Mask and Wafer Allowing Oblique Incidence

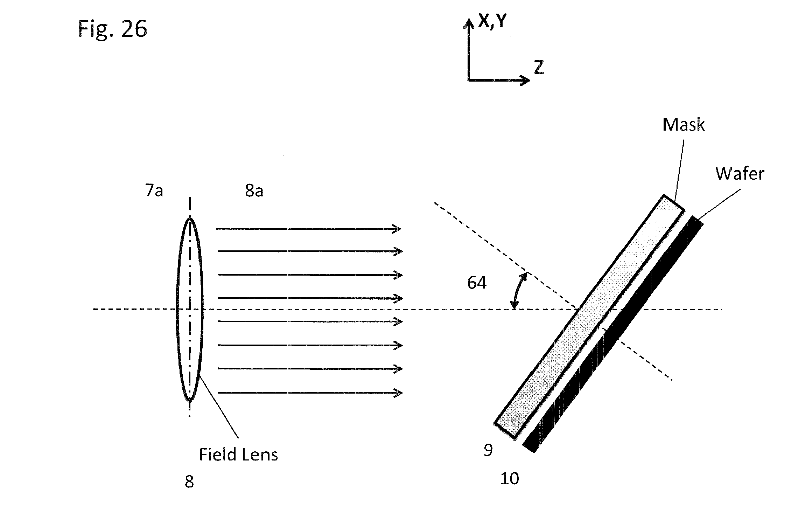

Fig. 26 is a meridional and considerably simplified view of a part of a microlithographic contact and proximity exposure apparatus in accordance with the present invention, where the mask 9 and the wafer 10 are tilted by an angle 64 versus illuminating light 8a impinging the mask 9. Typical off-axis illumination angles range from 0° to 90° for both X- and Y-direction. For illumination angles 64 close to 90°, and illumination of the side-walls of the mask 9 providing light guiding of the light within the mask 9 by total internal reflection or the use of additional prisms or gratings is preferable.

### 7.0 Alternative Illumination by Using a Polarizer

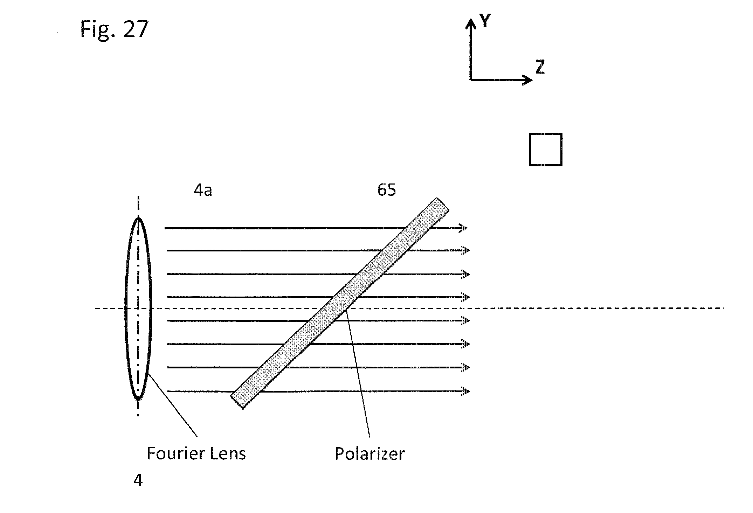

Fig. 27 is a meridional and considerably simplified view of a part of a microlithographic contact and proximity exposure apparatus in accordance with the present invention, where an additional Polarizer 65 is used to illuminate the mask 9 with polarized light. The preferred position of the polarizer 65 is behind the first Fourier lens 4, however, the said polarizer might also be located at any other position within the illumination system. Said polarizer 65 includes, but is not necessarily limited to one or multiple tilted plano-parallel plates (referred as Brewster plates), Brewster windows, prisms, wire-grid polarizers, polarizing crystals, organic polarizers, or any other element providing polarization within a lithography exposure apparatus.

According to the present invention, the following embodiments/items are provided as examples.
Item 1: An illumination system for a microlithographic contact and proximity exposure apparatus, comprising:
   a) a light source (1),
   b) a collector (2),
   c) a first optical integrator (3) that produces a plurality of secondary light sources (3b) each emitting a light bundle, and
   d) a first Fourier lens (4) effecting a superposition of the light bundles in a Fourier plane (4a), and
   e) a second optical integrator (6) that produces a plurality of tertiary light sources (6a) each emitting a light bundle, and
   f) a second Fourier lens (7) effecting a superposition of the light bundles in a Fourier plane (7a), and
   g) a field lens (8) located in the Fourier plane (7a) of second Fourier lens (7),
      wherein said first and second optical integrators (3, 6) are configured such that a mask (9) is illuminated with uniform irradiance and a uniform angular distribution.
Item 2: The illumination system of item 1, wherein said first and second optical integrators (3, 6) are configured such that a mask (9) is illuminated with uniform irradiance and a uniform angular distribution independent from the configuration of the lamp (1) and the collector (2).
Item 3: The illumination system of item 1, wherein said first and second optical integrators (3, 6) are configured such that a mask (9) is illuminated with uniform irradiance and a uniform angular distribution, whereas the angular distribution is defined by an angle defining element (5).
Item 4: The illumination system of item 1, wherein a first field lens (12) is located in the Fourier plane (4a) of first Fourier lens (4) and a second field lens (8) is located in the Fourier plane (7a) of second Fourier lens (7),
   wherein first field lens (12) ensures telecentric illumination of the second optical integrator (6) and the second field lens (8) ensures telecentric illumination of the mask (9).
Item 5: The illumination system of item 1, wherein said first and second optical integrators (3, 6) comprise two sub-elements (13, 14) configured such that a flat-top intensity distribution (4b) is obtained in the Fourier planes (4a, 7a) of subsequent Fourier lenses (4, 7).
Item 6: The illumination system of item 5, wherein said sub-elements (13, 14) of first and second optical integrators (3, 6) comprise two identical lens arrays (13a, 14a) located at a focal length distance f₁ = f₂ from each other.
Item 7: The illumination system of item 5, wherein said sub-elements (13, 14) of first and second optical integrators (3, 6) comprise two different lens arrays (13a, 14a), whereas the first array (13a) is located at or close to the front focal plane of the second lens array (14a).
Item 8: The illumination system of item 6, wherein said lens arrays (13a, 14a) are two-dimensional arrays (21, 22, 23, 25) of circular (21a), quadratic (23a) or hexagonal (25a) lens shape.
Item 9: The illumination system of item 6, wherein said lens arrays (13a, 14a) are one-dimensional arrays (24) of rectangular (24a) lens shape.
Item 10: The illumination system of item 5, wherein said sub-elements (13, 14) of first and second optical integrators (3, 6) comprise four identical arrays of cylindrical lenses (17a, 18a, 19a, 20a), wherein two lens array (18a, 20a) are rotated by 90° around Z direction, wherein first sub-element (13) comprises two lens array (17a, 18a) and second sub-element (14) comprises two lens array (19a, 20a) and wherein first lens array (17a) and third lens array (19a) are located at a focal length distance f₁ = f₃ from each other and wherein second lens array (18a) and fourth lens array (20a) are located at a focal length distance f₂ = f₄ from each other.
Item 11: The illumination system of item 3, wherein said angle defining element (5) is a filter plate (11), wherein filter plate (11) comprises transparent (11a) and opaque (11b) areas.
Item 12: The illumination system of item 6, wherein said filter plate (11), comprises transparent (11a) and opaque (11b) areas of (A) multiple circles (28a-d), (B) circles of different diameter (28e-h), (C) rings of different inner and outer diameter (28i-j), (D) Maltese Cross 0° (28k) and 45° rotated (281) or Quadrupole (28m) of any rotation, squares or rectangles (28n), squares or rectangles with Quadrupole (28o), multiple rectangules of different orientation (28p), square-type Quadrupole (20q), or comprises any other desired distribution of transparent (11a), semi-transparent and opaque (11b) areas.
Item 13: The illumination system of item 6, wherein said filter plate (11), comprises grey-level, refractive, diffractive, phase-shifting, Fresnel-type micro-optical elements, lenses, lens arrays, prisms, prism arrays, beam-splitters or beam-splitter arrays.
Item 14: The illumination system of item 3, wherein said angle defining element (5) comprises two or more variable sub-elements (29, 30).
Item 15: The illumination system of item 14, wherein said angle defining element (5) comprises a concave (29) and a convex axicon (30) providing annual (ring) illumination at the second optical integrator, wherein the Z-position of the convex axicon (30) is variable to change the dimensions (din, dₒᵤₜ) of the ring illumination (31a).
Item 16: The illumination system of item 14, wherein said angle defining element (5) comprises two variable sub-elements (29, 30), a combination of convex axicons (30a), pyramides (30b) or prism elements (30c) and its concave counterparts, wherein at least the Z-position of one element is variable.
Item 17: The illumination system of item 3, wherein said angle defining elements (5) comprises a light guiding rod (32) located at a variable position prior to the second optical integrator (6).
Item 18: The illumination system of item 3, wherein said angle defining elements (5) comprises a light guiding rod (32) and a variable mirror tube (33), both located at a variable Z-positions prior to the second optical integrator 6, wherein the outer dimensions of said light guiding rod (32) are slightly smaller than the inner dimensions of said variable mirror tube (33).
Item 19: The illumination system of item 3, wherein said angle defining element (5) is an absorbing or reflecting axial-symmetric element (36) located prior to the entrance pupil of the second optical integrator (6) to block the central part (apodization) and to absorb or redirect the incident light to larger angles, wherein said absorbing or reflecting axial-symmetric element (36) is variable in Z-direction providing annular (ring) illumination with different size of the dark zone (37a) in the center.
Item 20: The illumination system of item 18 or 19, wherein said angle defining elements (5) comprises a light guiding rod (32), a variable mirror tube (33) and an absorbing or reflecting axial-symmetric element (36); located at a variable Z-positions prior to the second optical integrator (6).
Item 21: The illumination system of item 6 or 11, wherein the size, position and distribution of the transparent (11a) and opaque (11b) areas on said filter plate (11) are variable in X- and Y-direction.
Item 22: The illumination system of item 6 or 11, wherein said filter plate (11) comprises a liquid crystal display or micro-mirror arrays in transmission or reflection.
Item 23: The illumination system of item 6 or 11, wherein said filter plate (11) is adapted to optical proximity correction structures (OPC) on the mask (9) to compensate diffraction and interference effects.
Item 24: The illumination system of item 1 wherein lamp (1), collector (2), optical integrator (3) and Fourier lens (4) are replaced by one or multiple light emitting flexible light guides (53), wherein said one or multiple light emitting flexible light guides (53) are variable in X-,Y-,Z-direction.
Item 25: The illumination system of item 1, 8 or 24, wherein said one or multiple light emitting flexible light guides (53) are combined with a re-directing element (36), whereas the positions of said light guides (53) and re-directing element (36) are variable in X-,Y-,Z-direction.
Item 26: The illumination system of item 1 wherein lamp (1), collector (2), optical integrator (3) and Fourier lens (4) are replaced by one or multiple light emitting LEDs (56), wherein said multiple light emitting LEDs (56) are mounted on an electronic board (55) in a regular (23c) or annular (23d) arrangement.
Item 27: The illumination system of item 1 or 26, wherein multiple light emitting LEDs (56) are combined with collimation optics (57).
Item 28: The illumination system of item 1, wherein the position (59a) of the second Fourier lens (7) is variable in Z-direction to change the degree of collimation (8a) behind the second field lens (8), wherein said change of Z-position (59a) of the second Fourier lens (7) introduces a change of angles (8b) of principle rays of the mask illuminating light (8a).
Item 29: The illumination system of item 1 or 28, wherein said change of angles (8b) of principle rays of the mask illuminating light (8a) introduce a shift of the lateral position (61a) of the miniature structures transferred from the mask (9) to the surface of the wafer (10) by proximity printing (correction of registration errors, also referred as run-out control).
Item 30: The illumination system of any of the preceding items, wherein the second Fourier lens (7) is replaced by a Fourier zoom lens (62) comprising two or multiple refractive lenses.
Item 31: The illumination system of any of the preceding items,
   wherein the second Fourier lens (7) is replaced by a hybrid Fourier lens (63) comprising one or multiple refractive lenses and one or multiple optical elements like for example diffractive optical elements, holographic elements, radial gratings, linear gratings, axicons or axicon telescopes, prisms, or prism arrays.
Item 32: The illumination system of item 13, 14, 30 or 31, wherein the Z-position of one or multiple sub-elements is variable.
Item 33: The illumination system of item 1, wherein collector (2) comprises a hemispherical mirror (40) and two half ellipsoids (41, 43), wherein the said two half ellipsoids (41, 43) have a common focal point (42) in order to provide an aberration-free image (44) of the lamp source (39).
Item 34: The illumination system of item 1, wherein collector (2) comprises two ellipsoids (2, 48) and an axial-symmetrical re-directing element (49), wherein said two ellipsoids (2, 48) have a common focal point (2a) in order to provide an aberration-free image of the lamp source (1) in the plane (48a) of the re-directing element (49).
Item 35: The illumination system of item 1, wherein said re-directing element (49) comprises two cones (49a, 49b) with different angles, changes the angles of the incident light and provides a collimated bundle of light (51) exiting the second ellipsoid (48) through a center hole (50).
Item 36: The illumination system of item 17 or 35, wherein the re-directing element (49) comprises a combination of surface reflection and total internal reflection suitable to re-direct the incident light towards the hole (51) in the second ellipsoid (48).
Item 37: The illumination system of any of the preceding items, wherein the mask (9) and the wafer (10) are tilted by an angle (64) versus the illuminating light (8a) impinging the mask (9).
Item 38: The illumination system of any of the preceding items, wherein the illumination light (8a) is polarized by a polarizing element (65) located in the illumination system, wherein said polarizing element (65) is one or multiple plano-parallel glass plate at Brewster angle, also referred as Brewster plate polarizers, one or multiple wire-grid plate polarizers or any other optical element providing polarized light within a lithographic exposure apparatus of present invention.
Item 39: The illumination system of any of the preceding items, wherein the angle defining element (5) is received in an exchange holder (linear or rotational).

## Claims

1. An illumination system for a microlithographic contact and proximity exposure apparatus, comprising:
a) a light source (1),
b) a collector (2),
c) a first optical integrator (3) that produces a plurality of secondary light sources (3b) each emitting a light bundle, and
d) a first Fourier lens (4) effecting a superposition of the light bundles in a Fourier plane (4a), and
e) a second optical integrator (6) that produces a plurality of tertiary light sources (6a) each emitting a light bundle, and
f) a second Fourier lens (7) effecting a superposition of the light bundles in a Fourier plane (7a), and
g) a field lens (8) located in the Fourier plane (7a) of second Fourier lens (7),
h) wherein said first and second optical integrators (3, 6) are configured such that a mask (9) is illuminated with uniform irradiance and a uniform angular distribution.

2. The illumination system of claim 1, wherein said first and second optical integrators (3, 6) are configured such that a mask (9) is illuminated with uniform irradiance and a uniform angular distribution independent from the configuration of the lamp (1) and the collector (2).

3. The illumination system of claim 1, wherein said first and second optical integrators (3, 6) are configured such that a mask (9) is illuminated with uniform irradiance and a uniform angular distribution, whereas the angular distribution is defined by an angle defining element (5).

4. The illumination system of claim 1, wherein a first field lens (12) is located in the Fourier plane (4a) of first Fourier lens (4) and a second field lens (8) is located in the Fourier plane (7a) of second Fourier lens (7), wherein first field lens (12) ensures telecentric illumination of the second optical integrator (6) and the second field lens (8) ensures telecentric illumination of the mask (9).

5. The illumination system of claim 1, wherein said first and second optical integrators (3, 6) comprise two sub-elements (13, 14) configured such that a flat-top intensity distribution (4b) is obtained in the Fourier planes (4a, 7a) of subsequent Fourier lenses (4, 7).

6. The illumination system of claim 3, wherein said angle defining element (5) is a filter plate (11), wherein filter plate (11) comprises transparent (11a) and opaque (11b) areas.

7. The illumination system of claim 6, wherein said filter plate (11) is adapted to optical proximity correction structures (OPC) on the mask (9) to compensate diffraction and interference effects.

8. The illumination system of claim 1 wherein lamp (1), collector (2), optical integrator (3) and Fourier lens (4) are replaced by one or multiple light emitting flexible light guides (53), wherein said one or multiple light emitting flexible light guides (53) are variable in X-,Y-,Z-direction.

9. The illumination system of claim 1 wherein lamp (1), collector (2), optical integrator (3) and Fourier lens (4) are replaced by one or multiple light emitting LEDs (56), wherein said multiple light emitting LEDs (56) are mounted on an electronic board (55) in a regular (23c) or annular (23d) arrangement.

10. The illumination system of claim 1 or 9, wherein multiple light emitting LEDs (56) are combined with collimation optics (57).

11. The illumination system of claim 1, wherein the position (59a) of the second Fourier lens (7) is variable in Z-direction to change the degree of collimation (8a) behind the second field lens (8), wherein said change of Z-position (59a) of the second Fourier lens (7) introduces a change of angles (8b) of principle rays of the mask illuminating light (8a).

12. The illumination system of claim 1 or 11, wherein said change of angles (8b) of principle rays of the mask illuminating light (8a) introduce a shift of the lateral position (61a) of the miniature structures transferred from the mask (9) to the surface of the wafer (10) by proximity printing (correction of registration errors, also referred as run-out control).

13. The illumination system of any of the preceding claims, wherein the second Fourier lens (7) is replaced by a Fourier zoom lens (62) comprising two or multiple refractive lenses.

14. The illumination system of any of the preceding claims, wherein the second Fourier lens (7) is replaced by a hybrid Fourier lens (63) comprising one or multiple refractive lenses and one or multiple optical elements like for example diffractive optical elements, holographic elements, radial gratings, linear gratings, axicons or axicon telescopes, prisms, or prism arrays.

15. The illumination system of claim 1, wherein collector (2) comprises a hemispherical mirror (40) and two half ellipsoids (41, 43), wherein the said two half ellipsoids (41, 43) have a common focal point (42) in order to provide an aberration-free image (44) of the lamp source (39).

16. The illumination system of claim 1, wherein collector (2) comprises two ellipsoids (2, 48) and an axial-symmetrical re-directing element (49), wherein said two ellipsoids (2, 48) have a common focal point (2a) in order to provide an aberration-free image of the lamp source (1) in the plane (48a) of the re-directing element (49).

17. The illumination system of claim 1, wherein said re-directing element (49) comprises two cones (49a, 49b) with different angles, changes the angles of the incident light and provides a collimated bundle of light (51) exiting the second ellipsoid (48) through a center hole (50).

18. The illumination system of any of the preceding claims, wherein the mask (9) and the wafer (10) are tilted by an angle (64) versus the illuminating light (8a) impinging the mask (9).

19. The illumination system of any of the preceding claims, wherein the illumination light (8a) is polarized by a polarizing element (65) located in the illumination system, wherein said polarizing element (65) is one or multiple plano-parallel glass plate at Brewster angle, also referred as Brewster plate polarizers, one or multiple wire-grid plate polarizers or any other optical element providing polarized light within a lithographic exposure apparatus of present invention.

20. The illumination system of any of the preceding claims, wherein the angle defining element (5) is received in an exchange holder (linear or rotational).
